(19) Europäisches Patentamt
European Patent Office
Office européen des brevets

(11) **EP 2 357 078 A1**

(12) **EUROPEAN PATENT APPLICATION**
published in accordance with Art. 153(4) EPC


(43) Date of publication:
**17.08.2011 Bulletin 2011/33**

(21) Application number: **09831960.1**

(22) Date of filing: **11.12.2009**

(51) Int Cl.:
***B32B 9/04*** *(2006.01)* ***B32B 27/00*** *(2006.01)*

(86) International application number:
**PCT/JP2009/070728**

(87) International publication number:
**WO 2010/067857 (17.06.2010 Gazette 2010/24)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **12.12.2008 JP 2008316691**
**26.03.2009 JP 2009076145**



(71) Applicant: **LINTEC Corporation**
**Tokyo 173-0001 (JP)**

(72) Inventors:
- **HOSHI Shinichi**
  **Tokyo 173-0001 (JP)**
- **KONDO Takeshi**
  **Tokyo 173-0001 (JP)**
- **YAMAGUCHI Seitaro**
  **Tokyo 173-0001 (JP)**
- **UEMURA Kazue**
  **Tokyo 173-0001 (JP)**
- **SUZUKI Yuta**
  **Tokyo 173-0001 (JP)**

(74) Representative: **Albrecht, Thomas**
**Kraus & Weisert**
**Patent- und Rechtsanwälte**
**Thomas-Wimmer-Ring 15**
**80539 München (DE)**


# (54) LAMINATE, METHOD FOR PRODUCING SAME, ELECTRONIC DEVICE MEMBER, AND ELECTRONIC DEVICE


(57) A laminate comprises a gas barrier layer and an inorganic compound layer, the gas barrier layer being formed of a material that includes at least an oxygen atom, a carbon atom, and a silicon atom, the gas barrier layer having an oxygen atom content rate that gradually decreases from the surface of the gas barrier layer in the depth direction, and having a carbon atom content rate that gradually increases from the surface of the gas barrier layer in the depth direction. An electronic device member includes the laminate, and an electronic device includes the electronic device member. The laminate exhibits an excellent gas barrier capability and excellent transparency, and does not produce cracks (i.e., the gas barrier capability does not deteriorate) even when the laminate is folded. The laminate exhibits an excellent gas barrier capability and an excellent impact-absorbing capability even if an impact is applied from the outside.


FIG. 1

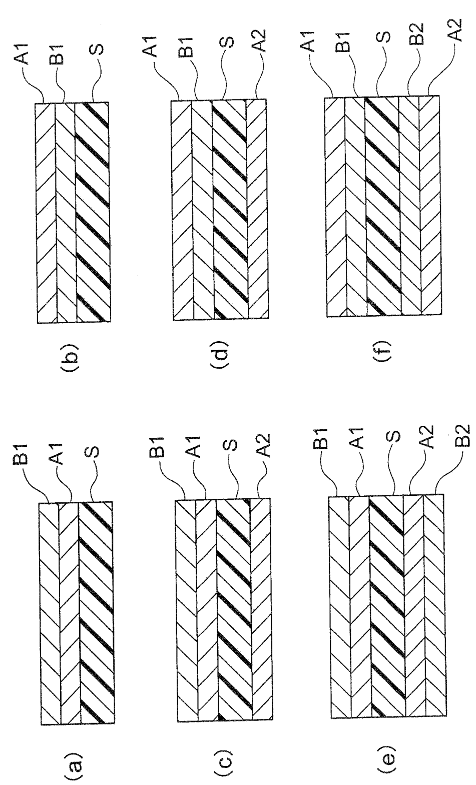


EP 2 357 078 A1

## Description

### TECHNICAL FIELD

The present invention relates to a laminate that exhibits an excellent gas barrier capability and excellent transparency, and rarely produces cracks even if the laminate is folded, a method of producing the laminate, an electronic device member that includes the laminate, and an electronic device that includes the electronic device member.
The invention also relates to a laminate that exhibits an excellent gas (e.g., water vapor) barrier capability, and does not produce cracks in an inorganic compound layer (i.e., the gas barrier capability does not deteriorate) even when an impact is applied from the outside, an electronic device member that includes the laminate, and an electronic device.

### BACKGROUND ART

In recent years, use of a transparent plastic film as a substrate instead of a glass sheet has been proposed for displays (e.g., liquid crystal display and electroluminescence (EL) display) in order to implement a reduction in thickness, a reduction in weight, an increase in flexibility, and the like.
However, since a plastic film tends to allow water vapor, oxygen, and the like to pass through as compared with a glass sheet, elements provided inside a display may deteriorate.
In order to solve this problem, Patent Documents 1 and 2 disclose a gas barrier sheet in which a gas barrier inorganic compound layer is stacked on a synthetic resin sheet.
However, the gas barrier capability of the resulting sheet is not necessarily satisfactory. The inorganic compound layer tends to produce cracks when the inorganic compound layer is folded (bent), so that the gas barrier capability may deteriorate to a large extent.
Moreover, cracks may occur in the gas barrier layer (e.g., inorganic oxide film) (i.e., the gas barrier capability may deteriorate) when an impact is applied from the outside.
In recent years, a solar cell has attracted attention as a clean energy source. A solar cell module is normally produced by stacking a glass sheet, an electrode, a light conversion layer, an electrode, a back-side protective sheet layer, and the like from the light-receiving side, sucking the layers under vacuum, and bonding the layers with heating (lamination method), for example. For example, Patent Document 3 discloses a solar cell module back-side protective sheet produced by depositing an inorganic oxide layer on one side of a weather-resistant substrate, and stacking a colored polyester resin layer on the inorganic oxide layer. Patent Document 4 discloses a solar cell back-side protective sheet formed of a fluororesin sheet having a thickness of 30 μm or less, and Patent Document 5 discloses an electric/electronic insulating sheet in which an aziridinyl group-containing adhesive resin layer is formed on at least one side of a fluorine-based film formed of a fluorine-containing resin and a resin that does not contain fluorine.
However, since the above sheets have an insufficient water vapor barrier capability (gas barrier capability), the electrodes and the light conversion layer may deteriorate. Moreover, the glass sheet or the inorganic oxide film formed on the protective sheet may break due to an impact from the outside.

### RELATED-ART DOCUMENT

### PATENT DOCUMENT

Patent Document 1: JP-A-2005-169994
Patent Document 2: JP-A-10-305542
Patent Document 3: JP-A-2001-119051
Patent Document 4: JP-A-2003-347570
Patent Document 5: JP-A-2004-352966

### SUMMARY OF THE INVENTION

### PROBLEMS TO BE SOLVED BY THE INVENTION

The invention was conceived in view of the above problems. An object of the invention is to provide a laminate that exhibits an excellent gas barrier capability and excellent transparency, and does not produce cracks even when the laminate is folded (bent), an electronic device member that includes the laminate, and an electronic device that includes the electronic device member, and also provide a laminate that exhibits an excellent gas barrier capability and an excellent

impact-absorbing capability even if an impact is applied from the outside.

MEANS FOR SOLVING THE PROBLEMS

The inventors conducted extensive studies in order to achieve the above object. As a result, the inventors found that a laminate that includes an inorganic compound layer, and a gas barrier layer that is formed of a material that includes at least an oxygen atom, a carbon atom, and a silicon atom, and has a configuration in which the oxygen atom content rate gradually decreases and the carbon atom content rate gradually increases from the surface of the gas barrier layer in the depth direction, exhibits an excellent gas barrier capability, excellent transparency, and excellent folding (bending) resistance.
The inventors also found that a laminate that includes an impact-absorbing layer in addition to the gas barrier layer and the inorganic compound layer exhibits an excellent gas (e.g., water vapor) barrier capability, and does not produce cracks in the inorganic compound layer (i.e., the gas barrier capability does not deteriorate) even when an impact is applied from the outside.
The inventors further found that the gas barrier layer can be easily and efficiently formed by implanting ions into a polyorganosiloxane compound-containing layer of a formed article that includes the polyorganosiloxane compound-containing layer in its surface area. These findings have led to the completion of the invention.
Specifically, the invention provides the following laminate (see (1) to (9)), method of producing a laminate (see (10) to (13)), electronic device member (see (14)), and electronic device (see (15)).
(1) A laminate comprising a gas barrier layer and an inorganic compound layer, the gas barrier layer being formed of a material that includes at least an oxygen atom, a carbon atom, and a silicon atom, the gas barrier layer having an oxygen atom content rate that gradually decreases from the surface of the gas barrier layer in the depth direction, and having a carbon atom content rate that gradually increases from the surface of the gas barrier layer in the depth direction.
(2) The laminate according to (1), wherein the surface layer part of the gas barrier layer has an oxygen atom content rate of 10 to 70%, a carbon atom content rate of 10 to 70%, and a silicon atom content rate of 5 to 35%, based on the total content of oxygen atoms, carbon atoms, and silicon atoms.
(3) The laminate according to (1), wherein the surface layer part of the gas barrier layer has a silicon atom 2p electron binding energy peak position determined by X-ray photoelectron spectroscopy (XPS) of 102 to 104 eV.

(4) The laminate according to (1), further including an impact-absorbing layer having a storage modulus at 25°C of $1\times10^2$ to $1\times10^9$ Pa.
(5) The laminate according to (1), further including an impact-absorbing layer that satisfies the following expressions (1) and (2),

[Expression 1]

$$300\ \mathrm{Pa\cdot cm} < E' \times L < 10^7\ \mathrm{Pa\cdot cm} \quad (1)$$
$$10^{-3}\ \mathrm{cm} < L < 0.05\ \mathrm{cm} \quad (2)$$

where, E' is the Young's modulus (Pa) of the impact-absorbing layer, and L is the thickness (cm) of the impact-absorbing layer.

(6) The laminate according to (1), the laminate having a water vapor permeability at a temperature of 40°C and a relative humidity of 90% of 0.1 g/m$^2$/day or less.
(7) The laminate according to (1), wherein the gas barrier layer is a layer produced by implanting ions into a polyorganosiloxane compound-containing layer.

(8) The laminate according to (7), wherein the ions have been produced by ionizing at least one gas selected from the group consisting of nitrogen, oxygen, argon, and helium.
(9) The laminate according to (7), wherein the polyorganosiloxane compound is a polyorganosiloxane that includes a repeating unit shown by the following formula (a) or (b),

[Chemical Formula 1]

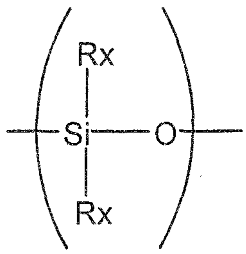

(a)

[Chemical Formula 2]

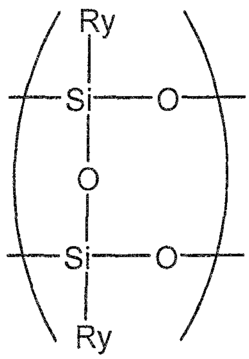

(b)

wherein Rx and Ry individually represent a hydrogen atom or a non-hydrolyzable group such as a substituted or unsubstituted alkyl group, a substituted or unsubstituted alkenyl group, or a substituted or unsubstituted aryl group. Note that a plurality of Rx in the formula (a) and a plurality of Ry in the formula (b) may respectively be either the same or different, and a case where both Rx in the formula (a) represent a hydrogen atom is excluded.

(10) A method of producing the laminate according to any one of (7) to (9), the method including implanting ions into a polyorganosiloxane compound-containing layer of a formed article that includes the polyorganosiloxane compound-containing layer in its surface area to form the gas barrier layer.
(11) The method according to (10), wherein the ions are produced by ionizing at least one gas selected from the group consisting of nitrogen, oxygen, argon, and helium.
(12) The method according to (10), wherein the ions are implanted by plasma ion implantation.

(13) The method according to (10), wherein the ions are implanted into the polyorganosiloxane compound-containing layer while transferring a long formed article that includes the polyorganosiloxane compound-containing layer in its surface area in a given direction.
(14) An electronic device member including the laminate according to any one of (1) to (9).
(15) An electronic device including the electronic device member according to (14).

EFFECTS OF THE INVENTION

The above laminate exhibits an excellent gas barrier capability, and does not produce cracks (i.e., the gas barrier capability does not deteriorate) even when the laminate is folded (bent).
The laminate that includes the impact-absorbing layer exhibits an excellent gas barrier capability and an excellent impact-absorbing capability. Specifically, cracks do not occur in the inorganic compound layer (i.e., the gas barrier capability does not deteriorate) even when an impact is applied from the outside.
Therefore, the above laminate may suitably be used for an electronic device member (particularly a solar cell back-side protective sheet, a touch panel, a flexible display, and the like).
The above laminate may be efficiently produced by the above method. The above laminate exhibits excellent folding resistance, and allows roll-to-roll mass-production.

BRIEF DESCRIPTION OF THE DRAWINGS

FIG. 1 is a cross-sectional view showing the layer configuration of a laminate according to one embodiment of the invention.
FIG. 2 is a cross-sectional view showing the layer configuration of a laminate according to one embodiment of the invention.
FIG. 3 is a view schematically showing the configuration of a plasma ion implantation apparatus.
FIG. 4 is a view schematically showing the configuration of a continuous magnetron sputtering apparatus.
FIG. 5 is a view showing the oxygen atom content rate (%), the carbon atom content rate (%), and the silicon atom content rate (%) in a gas barrier layer of a laminate 1 of Example 1.
FIG. 6 is a view showing the oxygen atom content rate (%), the carbon atom content rate (%), and the silicon atom content rate (%) in a gas barrier layer of a laminate 2 of Example 2.
FIG. 7 is a view showing the oxygen atom content rate (%), the carbon atom content rate (%), and the silicon atom content rate (%) in a gas barrier layer of a laminate 3 of Example 3.
FIG. 8 is a view showing the oxygen atom content rate (%), the carbon atom content rate (%), and the silicon atom content rate (%) in a polydimethylsiloxane-containing layer before ion implantation.
FIG. 9 is a view showing the XPS analysis results for the distribution of the silicon atom 2p electron binding energy in a laminate 1 of Example 1.

DESCRIPTION OF EXEMPLARY EMBODIMENTS

A laminate, a method of producing the same, an electronic device member, and an electronic device according to embodiments of the invention are described in detail in below.

1) Laminate

A laminate according to one embodiment of the invention includes a gas barrier layer and an inorganic compound layer, the gas barrier layer being formed of a material that includes at least an oxygen atom, a carbon atom, and a silicon atom, the gas barrier layer having an oxygen atom content rate that gradually decreases from the surface of the gas barrier layer in the depth direction, and having a carbon atom content rate that gradually increases from the surface of the gas barrier layer in the depth direction.

(Gas barrier layer)

The gas barrier layer (hereinafter may be referred to as "layer A") included in the laminate according to one embodiment of the invention is formed of a material that includes at least an oxygen atom, a carbon atom, and a silicon atom, the gas barrier layer having an oxygen atom content rate that gradually decreases from the surface of the gas barrier layer in the depth direction, and having a carbon atom content rate that gradually increases from the surface of

the gas barrier layer in the depth direction.

The material that includes at least an oxygen atom, a carbon atom, and a silicon atom is not particularly limited insofar as the material is a polymer that includes at least an oxygen atom, a carbon atom, and a silicon atom. From the viewpoint of obtaining a more excellent gas barrier capability, it is preferable that the surface layer part of the gas barrier layer have an oxygen atom content rate of 10 to 70%, a carbon atom content rate of 10 to 70%, and a silicon atom content rate of 5 to 35%, based on the total content (=100%) of oxygen atoms, carbon atoms, and silicon atoms. It is more preferable that the surface layer part of the gas barrier layer have an oxygen atom content rate of 15 to 65%, a carbon atom content rate of 15 to 65%, and a silicon atom content rate of 10 to 30%. The oxygen atom content rate, the carbon atom content rate, and the silicon atom content rate are measured by the method described in the examples.

The area where the oxygen atom content rate gradually decreases and the carbon atom content rate gradually increases from the surface in the depth direction is an area that corresponds to the gas barrier layer. The thickness of the gas barrier layer is normally 5 to 100 nm, and preferably 10 to 50 nm. Examples of the gas barrier layer include a layer produced by implanting ions into a polyorganosiloxane compound-containing layer (hereinafter may be referred to as "implanted layer"), and a layer produced by subjecting a polyorganosiloxane compound-containing layer to a plasma treatment.

It is preferable that the surface layer part of the gas barrier layer have a silicon atom 2p electron binding energy peak position determined by X-ray photoelectron spectroscopy (XPS) of 102 to 104 eV.

For example, a polydimethylsiloxane layer has a silicon atom 2p electron binding energy peak position determined by X-ray photoelectron spectroscopy (XPS) of about 101.5 eV. On the other hand, the surface layer part of an ion-implanted layer (gas barrier layer) produced by implanting argon ions into the polydimethylsiloxane layer has a silicon atom 2p electron binding energy peak position determined by X-ray photoelectron spectroscopy (XPS) of about 103 eV. This value is almost equal to that of a known silicon-containing polymer that has a gas barrier capability (e.g., glass or silicon dioxide film) (glass has a silicon atom 2p electron binding energy peak position determined by X-ray photoelectron spectroscopy (XPS) of about 102.5 eV, and a silicon dioxide film has a silicon atom 2p electron binding energy peak position determined by X-ray photoelectron spectroscopy (XPS) of about 103 eV). Specifically, since the formed article according to one embodiment of the invention, in which the surface layer part of the gas barrier layer has a silicon atom 2p electron binding energy peak position of 102 to 104 eV, has a structure identical with or similar to that of glass or a silicon dioxide film, the formed article exhibits an excellent gas barrier capability. The silicon atom 2p electron binding energy peak position is measured by the method described in the examples.

The laminate according to one embodiment of the invention preferably includes a polyorganosiloxane compound. It is preferable that the gas barrier layer be formed in the surface area of a polyorganosiloxane compound-containing layer having a thickness of 30 nm to 200 μm, and have a depth of 5 to 100 nm, and more preferably 30 to 50 nm.

It is more preferable that the gas barrier layer have been produced by implanting ions into a polyorganosiloxane compound-containing layer.

The main chain structure of the polyorganosiloxane compound used for the laminate according to one embodiment of the invention is not particularly limited. The main chain structure of the polyorganosiloxane compound may be linear, ladder-like, or polyhedral.

Examples of the linear main chain structure of the polyorganosiloxane compound include a structure shown by the following formula (a). Examples of the ladder-like main chain structure of the polyorganosiloxane compound include a structure shown by the following formula (b). Examples of the polyhedral main chain structure of the polyorganosiloxane compound include a structure shown by the following formula (c). Among these, the structure shown by the formula (a) or (b) is preferable.

[Chemical Formula 3]

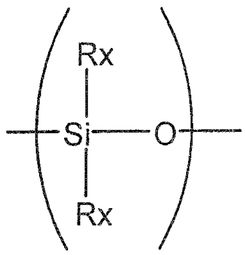

(a)

[Chemical Formula 4]

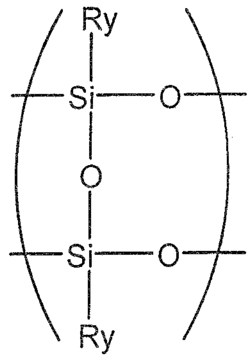

(b)

[Chemical Formula 5]

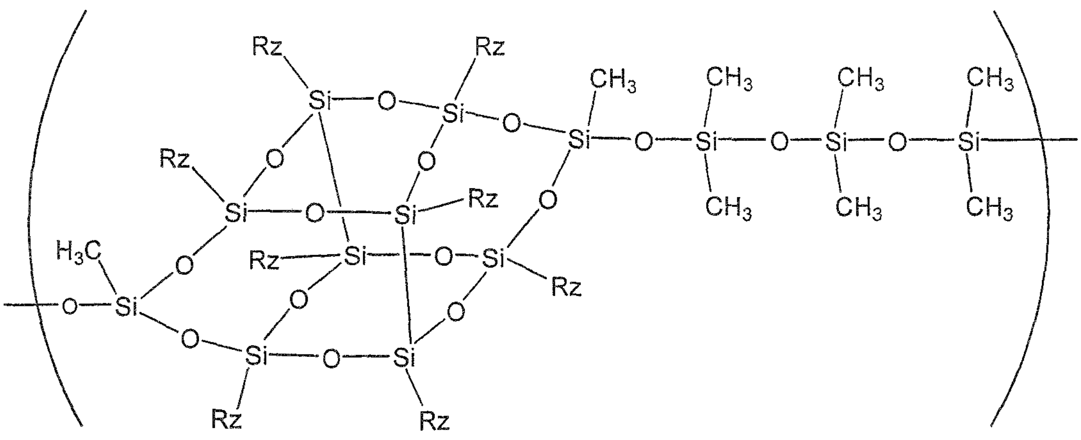

(c)

wherein Rx, Ry, and Rz individually represent a hydrogen atom or a non-hydrolyzable group such as a substituted or unsubstituted alkyl group, a substituted or unsubstituted alkenyl group, or a substituted or unsubstituted aryl group. Note that a plurality of Rx in the formula (a), a plurality of Ry in the formula (b), and a plurality of Rz in the formula (c) may respectively be either the same or different, and a case where both Rx in the formula (a) represent a hydrogen atom is excluded.

Examples of the substituted or unsubstituted alkyl group include alkyl groups having 1 to 10 carbon atoms (e.g., methyl group, ethyl group, n-propyl group, isopropyl group, n-butyl group, isobutyl group, sec-butyl group, t-butyl group, n-pentyl group, isopentyl group, neopentyl group, n-hexyl group, n-heptyl group, and n-octyl group).

Examples of the alkenyl group include alkenyl groups having 2 to 10 carbon atoms (e.g., vinyl group, 1-propenyl group, 2-propenyl group, 1-butenyl group, 2-butenyl group, and 3-butenyl group).

Examples of a substituent for the alkyl group and the alkenyl group include halogen atoms such as a fluorine atom, a chlorine atom, a bromine atom, and an iodine atom; a hydroxyl group; a thiol group; an epoxy group; a glycidoxy group; a (meth)acryloyloxy group; substituted or unsubstituted aryl groups such as a phenyl group, a 4-methylphenyl group, and a 4-chlorophenyl group; and the like.

Examples of the substituted or unsubstituted aryl group include aryl groups having 6 to 10 carbon atoms (e.g., phenyl group, 1-naphthyl group, and 2-naphthyl group).

Examples of a substituent for the aryl group include halogen atoms such as a fluorine atom, a chlorine atom, a bromine atom, and an iodine atom; alkyl groups having 1 to 6 carbon atoms, such as a methyl group and an ethyl group; alkoxy groups having 1 to 6 carbon atoms, such as a methoxy group and an ethoxy group; a nitro group; a cyano group; a hydroxyl group; a thiol group; an epoxy group; a glycidoxy group; a (meth)acryloyloxy group; substituted or unsubstituted aryl groups such as a phenyl group, a 4-methylphenyl group, and a 4-chlorophenyl group; and the like.

It is preferable that Rx, Ry, and Rz individually represent a substituted or unsubstituted alkyl group having 1 to 6 carbon atoms or a phenyl group, and particularly preferably a methyl group, an ethyl group, a propyl group, a 3-glycidoxypropyl group, or a phenyl group.

Note that a plurality of Rx in the formula (a), a plurality of Ry in the formula (b), and a plurality of Rz in the formula (c) may respectively be either the same or different.

The polyorganosiloxane compound is preferably a linear compound shown by the formula (a) or a ladder-like compound shown by the formula (b), and particularly preferably a linear compound shown by the formula (a) in which Rx represent a methyl group or a phenyl group, or a ladder-like compound shown by the formula (b) in which Ry represent a methyl group, a propyl group, a 3-glycidoxypropyl group, or a phenyl group, from the viewpoint of availability and a capability to form an implanted layer that exhibits an excellent gas barrier capability.

The polyorganosiloxane compound may be produced by a known method that polycondenses a silane compound including a hydrolyzable functional group.

The silane compound may be appropriately selected depending on the structure of the target polyorganosiloxane compound. Specific examples of a preferable silane compound include bifunctional silane compounds such as dimethyldimethoxysilane, dimethyldiethoxysilane, diethyldimethoxysilane, and diethyldiethoxysilane; trifunctional silane compounds such as methyltrimethoxysilane, methyltriethoxysilane, ethyltrimethoxysilane, ethyltriethoxysilane, n-propyltrimethoxysilane, n-butyltriethoxysilane, 3-glycidoxypropyltrimetoxysilane, phenyltrimethoxysilane, phenyltriethoxysilane, and phenyldiethoxymethoxysilane; tetrafunctional silane compounds such as tetramethoxysilane, tetraethoxysilane, tetra-n-propoxysilane, tetraisopropoxysilane, tetra-n-butoxysilane, tetra-t-butoxysilane, tetra-s-butoxysilane, methoxytriethoxysilane, dimethoxydiethoxysilane, and trimethoxyethoxysilane; and the like.

A product commercially available as a release agent, an adhesive, a sealant, a paint, or the like may be used as the polyorganosiloxane compound.

The polyorganosiloxane compound-containing layer may include a component other than a polyorganosiloxane compound insofar as the object of the invention can be achieved. Examples of a component other than the polyorganosiloxane compound include a curing agent, another polymer, an aging preventive, a light stabilizer, a flame retardant, and the like.

The content of the polyorganosiloxane compound in the polyorganosiloxane compound-containing layer is preferably 50 wt% or more, more preferably 70 wt% or more, and particularly preferably 90 wt% or more, from the viewpoint of obtaining an implanted layer that exhibits an excellent gas barrier capability.

The polyorganosiloxane compound-containing layer may be formed by an arbitrary method. For example, the polyorganosiloxane compound-containing layer may be formed by applying a solution that includes at least one polyorganosiloxane compound, an optional component, and a solvent to an appropriate substrate, drying the resulting film, and optionally heating the dried film.

The thickness of the polyorganosiloxane compound-containing layer is not particularly limited, but is normally 30 nm to 200 $\mu$m, and preferably 50 nm to 100 $\mu$m.

The implanted layer is produced by implanting ions into the polyorganosiloxane compound-containing layer. The dose may be appropriately determined depending on the usage of the laminate (e.g., gas barrier capability and transparency), and the like.

Examples of ions implanted include rare gases such as argon, helium, neon, krypton, and xenon; ions of fluorocarbons, hydrogen, nitrogen, oxygen, carbon dioxide, chlorine, fluorine, sulfur, and the like; ions of conductive metals such as gold, silver, copper, platinum, nickel, palladium, chromium, titanium, molybdenum, niobium, tantalum, tungsten, and aluminum; and the like.

Among these, at least one ion selected from the group consisting of ions of hydrogen, oxygen, nitrogen, rare gas, and fluorocarbons is preferable due to ease of implantation and a capability to form an implanted layer that exhibits an excellent gas barrier capability and excellent transparency. It is particularly preferable to use ions of nitrogen, oxygen, argon, or helium.

The ion implantation method is not particularly limited. For example, a method that includes forming a polyorganosiloxane compound-containing layer, and implanting ions into the polyorganosiloxane compound-containing layer may be used.

Ions may be implanted by applying ions (ion beams) accelerated by an electric field, implanting ions present in plasma (plasma ion implantation), or the like. It is preferable to use plasma ion implantation since a gas barrier laminate can be conveniently obtained.

Plasma ion implantation may be implemented by generating plasma in an atmosphere containing a plasma-generating gas (e.g., rare gas), and implanting ions (cations) in the plasma into the surface area of the polyorganosiloxane compound-containing layer by applying a negative high-voltage pulse to the polyorganosiloxane compound-containing layer, for example.

Implantation of ions may be confirmed by subjecting the surface layer part of the gas barrier layer to elemental analysis by X-ray photoelectron spectroscopy (XPS).

(Inorganic compound layer)

The laminate according to one embodiment of the invention further includes an inorganic compound layer (hereinafter may be referred to as "layer B"). The inorganic compound layer includes one or more inorganic compounds. Examples of the inorganic compound that forms the layer B include inorganic compounds that can be deposited under vacuum, and exhibit a gas barrier capability, such as inorganic oxides, inorganic nitrides, inorganic carbides, inorganic sulfides, and composites thereof (e.g., inorganic oxynitride, inorganic oxycarbide, inorganic carbonitride, and inorganic oxycarbonitride). Among these, it is preferable to use an inorganic oxide, an inorganic nitride, or an inorganic oxynitride.

Examples of the inorganic oxide include metal oxides shown by the general formula MOx.

In the general formula MOx, M represents a metal element. The range of x differs depending on M. For example, x=0.1 to 2.0 when M is silicon (Si), x=0.1 to 1.5 when M is aluminum (Al), x=0.1 to 1.0 when M is magnesium (Mg), x=0.1 to 1.0 when M is calcium (Ca), x=0.1 to 0.5 when M is potassium (K), x=0.1 to 2.0 when M is tin (Sn), x=0.1 to 0.5 when M is sodium (Na), x=0.1 to 1.5 when M is boron (B), x=0.1 to 2.0 when M is titanium (Ti), x=0.1 to 1.0 when M is lead (Pb), x=0.1 to 2.0 when M is zirconium (Zr), and x=0.1 to 1.5 when M is yttrium (Y).

It is preferable to use a silicon oxide (M=silicon), an aluminum oxide (M=aluminum), or a titanium oxide (M=titanium) due to excellent transparency and the like. It is more preferable to use a silicon oxide. It is preferable that x=1.0 to 2.0 when M is silicon, x=0.5 to 1.5 when M is aluminum, and x=1.3 to 2.0 when M is titanium.

Examples of the inorganic nitride include metal nitrides shown by the general formula MNy.

In the general formula MNy, M represents a metal element. The range of y differs depending on M. For example, y=0.1 to 1.3 when M is silicon (Si), y=0.1 to 1.1 when M is aluminum (A1), y=0.1 to 1.3 when M is titanium (Ti), and y=0.1 to 1.3 when M is tin (Sn).

It is preferable to use a silicon nitride (M=silicon), an aluminum nitride (M=aluminum), a titanium nitride (M=titanium), or a tin nitride (M=tin) due to excellent transparency and the like. It is more preferable to use a silicon nitride (SiN). It is preferable that y=0.5 to 1.3 when M is silicon, y=0.3 to 1.0 when M is aluminum, y=0.5 to 1.3 when M is titanium, and y=0.5 to 1.3 when M is tin.

Examples of the inorganic oxynitride include metal oxynitrides shown by the general formula MOxNy.

In the general formula MOxNy, M represents a metal element. The ranges of x and y differ depending on M. For example, x=1.0 to 2.0 and y=0.1 to 1.3 when M is silicon (Si), x=0.5 to 1.0 and y=0.1 to 1.0 when M is aluminum (A1), x=0.1 to 1.0 and y=0.1 to 0.6 when M is magnesium (Mg), x=0.1 to 1.0 and y=0.1 to 0.5 when M is calcium (Ca), x=0.1 to 0.5 and y=0.1 to 0.2 when M is potassium (K), x=0.1 to 2.0 and y=0.1 to 1.3 when M is tin (Sn), x=0.1 to 0.5 and y=0.1 to 0.2 when M is sodium (Na), x=0.1 to 1.0 and y=0.1 to 0.5 when M is boron (B), x=0.1 to 2.0 and y=0.1 to 1.3 when M is titanium (Ti), x=0.1 to 1.0 and y=0.1 to 0.5 when M is lead (Pb), x=0.1 to 2.0 and y=0.1 to 1.0 when M is zirconium (Zr), and x=0.1 to 1.5 and y=0.1 to 1.0 when M is yttrium (Y).

It is preferable to use a silicon oxynitride (M=silicon), an aluminum oxynitride (M=aluminum), or a titanium oxynitride (M=titanium) due to excellent transparency and the like. It is more preferable to use a silicon oxynitride. It is preferable that x=1.0 to 2.0 and y=0. to 1.3 when M is silicon, x=0.5 to 1.0 and y=0. to 1.0 when M is aluminum, and x=1.0 to 2.0 and y=0.1 to 1.3 when M is titanium.

The layer B may be formed by an arbitrary method. For example, the layer B may be formed by deposition, sputtering, ion plating, thermal CVD, plasma CVD, or the like.

For example, when forming the layer B by deposition, an inorganic compound material placed in a crucible is vaporized by heating and caused to adhere to a deposition target (e.g., substrate) by resistive heating; high-frequency induction heating; beam (e.g., electron beam or ion beam) heating; or the like to obtain a thin film.

When forming the layer B by sputtering, a discharge gas (e.g., argon) is introduced into a vacuum chamber. A high-frequency voltage or a direct voltage is applied between an inorganic compound target and a deposition target (e.g., a substrate such as a plastic film) to generate plasma, and plasma collides against the target so that the target material adheres to the deposition target to obtain a thin film. Examples of the target include the above metal oxides,

metal nitrides, metal oxynitrides, and metals contained therein.

It is preferable to form the layer B by sputtering since the layer B can be easily formed.

Examples of sputtering include two-electrode sputtering; three-electrode sputtering that further utilizes a hot cathode that discharges thermoelectrons; magnetron sputtering that stabilizes plasma and increases the deposition rate by applying a magnetic field to the surface of the target using a magnetic field generating means; ion-beam sputtering that applies high-energy ion beams to the target; facing target sputtering that applies a magnetic field perpendicularly to the surface of two targets disposed in parallel; ECR sputtering that utilizes electron cyclotron resonance (ECR); coaxial sputtering that coaxially disposes the target and the substrate in a cylindrical shape; reactive sputtering that supplies a reactive gas to the vicinity of the substrate, and controls the composition; and the like.

Among these, it is preferable to use magnetron sputtering since a laminate that exhibits an excellent gas barrier capability can be easily obtained.

The thickness of the layer B is determined depending on the application of the laminate, but is normally 10 to 1000 nm, preferably 20 to 500 nm, and more preferably 20 to 100 nm.

The inorganic compound layer normally exhibits a gas barrier capability. If the thickness of the inorganic compound layer is increased to a large extent in order to improve the gas barrier capability, the folding resistance and the transparency may decrease, and cracks may easily occur. Moreover, the weight of the laminate increases.

Since the laminate according to one embodiment of the invention includes the layer A in addition to the inorganic compound layer, the laminate exhibits an excellent gas barrier capability without increasing the thickness of the inorganic compound layer to a large extent.

(Laminate)

The laminate according to one embodiment of the invention may have a two-layer structure that includes the layer A and the layer B, or may have a muti-layer structure that includes a plurality of layers A and/or a plurality of layers B. The laminate according to one embodiment of the invention may further include an additional layer such as an impact-absorbing layer or an adhesive layer (described later). The additional layer may be a single layer, or may include a plurality of identical or different layers.

It is preferable that the laminate according to one embodiment of the invention have a configuration in which the layer produced by implanting ions into the polyorganosiloxane compound-containing layer (i.e., a layer including the layer A) and the layer B are directly stacked. This makes it possible to effectively suppress a situation in which cracks occur in the layer B, so that a laminate that exhibits excellent folding resistance and an excellent gas barrier capability can be obtained.

It is preferable that the laminate according to one embodiment of the invention have a configuration in which the layer A and the layer B are stacked on a base film from the viewpoint of ease of handling, ease of production, and the like.

A material for the base film is not particularly limited insofar as the objective of the laminate is not impaired. It is preferable to use a resin film as the base film in order to implement a reduced weight and flexibility. Examples of the material for the resin film include polyimides, polyamides, polyamideimides, polyphenylene ethers, polyether ketones, polyether ether ketones, polyolefins, polyesters, polycarbonates, polysulfones, polyether sulfones, polyphenylene sulfides, polyallylates, acrylic resins, cycloolefin polymers, aromatic polymers, and the like.

Among these, polyesters, polyamides, or cycloolefin polymers are preferable due to excellent transparency and versatility. It is more preferable to use polyesters or cycloolefin polymers.

Examples of the polyesters include polyethylene terephthalate, polybuthylene terephthalate, polyethylene naphthalate, polyallylate, and the like.

Examples of the polyamides include wholly aromatic polyamides, nylon 6, nylon 66, nylon copolymers, and the like.

Examples of the cycloolefin polymers include norbornene polymers, monocyclic olefin polymers, cyclic conjugated diene polymers, vinyl alicyclic hydrocarbon polymers, and hydrogenated products thereof. Specific examples of the cycloolefin polymers include Apel (ethylene-cycloolefin copolymer manufactured by Mitsui Chemicals Inc.), Arton (norbornene polymer manufactured by JSR Corporation), Zeonor (norbornene polymer manufactured by Zeon Corporation), and the like.

The thickness of the base film is not particularly limited, but is normally 5 to 1000 $\mu$m, and preferably 10 to 300 $\mu$m.

When the laminate according to one embodiment of the invention includes the base film, the numbers of the layers A and B and the arrangement of the layers A and B are not particularly limited. The layers A and B may be formed on one side or each side of the base film. Elevations and depressions (minute protrusions) on the surface of the base film are covered by stacking the layer A on the base film, so that the flatness is improved. A situation in which pinholes are formed in the layer B is suppressed by stacking the layer B on the layer A, so that a laminate that exhibits an excellent gas barrier capability is obtained. The inorganic compound may not adhere to the base film depending on the type of base film. However, sufficient adhesion can be obtained by providing the layer A between the base film and the layer B.

(Impact-absorbing layer)

The laminate according to one embodiment of the invention may further include an impact-absorbing layer (hereinafter may be referred to as "layer C") in addition to the gas barrier layer and the inorganic compound layer. The laminate impact-absorbing layer preferably has a storage modulus at 25°C of $1\times1$ or to $1\times10^9$ Pa, more preferably $1\times10^3$ to $1\times10^7$ Pa, and still more preferably $1\times10^4$ to $1\times10^6$ Pa. The storage modulus is measured by a torsional shear method at a frequency of 1 Hz using a dynamic viscoelasticity analyzer.
A laminate that exhibits an excellent impact-absorbing capability (i.e., cracks do not occur in the inorganic compound layer (i.e., the gas barrier capability does not deteriorate) even when an impact is applied) can be obtained by providing the impact-absorbing layer.

The material used for the impact-absorbing layer is not particularly limited. Examples of the material used for the impact-absorbing layer include acrylic resins, olefin resins, urethane resins, silicone resins, rubber materials, polyvinyl chloride, and the like.
Among these, acrylic resins, olefin resins, silicone resins and rubber materials are preferable. It is more preferable to use acrylic resins or olefin resins.

Examples of the acrylic resins include acrylic resins including at least one polymer selected from a (meth) acrylate homopolymer, a copolymer of two or more (meth)acrylate units, and a copolymer of a (meth)acrylate and another functional monomer as the main component. Note that the term "(meth)acrylic acid" refers to acrylic acid or methacrylic acid (hereinafter the same).

It is preferable to use a (meth)acrylate in which the ester moiety has 1 to 20 carbon atoms, and more preferably a (meth)acrylate in which the ester moiety has 4 to 10 carbon atoms, since the storage modulus of the impact-absorbing layer can be easily adjusted with a given range. Examples of the (meth)acrylate include butyl (meth)acrylate, pentyl (meth)acrylate, hexyl (meth)acrylate, heptyl (meth)acrylate, octyl (meth)acrylate, 2-ethylhexyl (meth)acrylate, nonyl (meth)acrylate, decyl (meth)acrylate, and the like.

Examples of the functional monomer include hydroxyl group-containing monomers such as hydroxyethyl (meth) acrylate, amide group-containing monomers such as (meth)acrylamide, carboxylic acid group-containing monomers such as (meth)acrylic acid, and the like.

The (meth)acrylate (co)polymer may be produced by solution polymerization, emulsion polymerization, suspension polymerization, or the like. Note that the term "(co)polymer" refers to a homopolymer or a copolymer (hereinafter the same).

The (meth)acrylate (co)polymer may be mixed with a crosslinking agent, and a least partially crosslinked.
Examples of the crosslinking agent include isocyanate crosslinking agents such as tolylene diisocyanate, hexamethylene diisocyanate, and adducts thereof; epoxy crosslinking agents such as ethylene glycol glycidyl ether; aziridine crosslinking agents such as hexa[1-(2-methyl)-aziridinyl]triphosphatriazine; chelate crosslinking agents such as aluminum chelates; and the like.

The crosslinking agent is used in an amount of 0.01 to 10 parts by mass, and preferably 0.05 to 5 parts by mass, based on 100 parts by mass (solid content) of the (meth)acrylate (co)polymer. These crosslinking agents may be used either individually or in combination.

Examples of the olefin resin include low-density polyethylene, linear low-density polyethylene, polypropylene, polybutene, an ethylene-vinyl acetate copolymer, an ethylene-(meth)acrylic acid copolymer, an ethylene-(meth)acrylate copolymer, and the like.

Examples of the silicone resin include silicone resins including a dimethylsiloxane as the main component. Examples of the rubber material include rubber materials including isoprene rubber, styrene-butadiene rubber, polyisobutylene rubber, styrene-butadiene-styrene rubber, or the like as the main component.

The impact-absorbing layer may be a laminate of these materials.
The impact-absorbing layer may be a sheet produced by extruding a thermoplastic resin, or may be a sheet produced by forming a thin film of a curable resin using a specific means, and curing the thin film.

Examples of the curable resin include a curable resin produced from a resin composition that includes an energy ray-curable oligomer (e.g., urethane acrylate) (base resin), an acrylate monomer having a relatively bulky group (e.g., isobornyl acrylate) (diluent), and an optional photoinitiator.

The impact-absorbing layer may include additives such as an antioxidant, a tackifier, a plasticizer, a UV absorber, a coloring agent, and an antistatic agent.

The impact-absorbing layer may be formed by an arbitrary method. For example, the impact-absorbing layer may be formed by applying a solution that includes the material (e.g., pressure-sensitive adhesive) for the impact-absorbing layer and an optional component (e.g., solvent) to the layer on which the impact-absorbing layer is to be formed, drying the resulting film, and optionally heating the dried film in the same manner as in the case of forming the polyorganosiloxane compound-containing layer.
Alternatively, the impact-absorbing layer may be deposited on a release base, and transferred to the layer on which the

impact-absorbing layer is to be formed.
The thickness of the impact-absorbing layer is normally 1 to 500 μm, and preferably 5 to 100 μm.

It is preferable that the impact-absorbing layer satisfy the following expressions (1) and (2) (where, E' is the Young's modulus (Pa) of the impact-absorbing layer, and L is the thickness (cm) of the impact-absorbing layer) in order to obtain an excellent impact-absorbing capability.

[Expression 2]

$$300\,Pa\cdot cm < E' \times L < 10^{7}\,Pa\cdot cm \quad (1)$$

$$10^{-3}\,cm < L < 0.05\,cm \quad (2)$$

The Young's modulus E' of the impact-absorbing layer is measured in accordance with JIS K 7161:1994 and JIS K 7127:1999 (the details thereof are described in the examples).

When the laminate according to one embodiment of the invention includes the impact-absorbing layer, the laminate according to one embodiment of the invention includes at least one layer A, at least one layer B, and at least one layer C, and may include only one layer A, one layer B, and one layer C, or may include a plurality of layers A and/or a plurality of layers B and/or a plurality of layers C. The layers A, B, and C may be stacked in an arbitrary order. It is preferable that the layers B and C be directly stacked on each other.
The laminate according to one embodiment of the invention may include an additional layer (e.g., base film or adhesive layer) in addition to the layers A, B, and C. The additional layer may be a single layer, or may include a plurality of identical or different layers.

It is preferable that the laminate according to one embodiment of the invention include the base film from the viewpoint of ease of handling, ease of production, and the like.

The material used for the base film is not particularly limited insofar as the objective of the laminate is not impaired. It is preferable to use a resin film as the base film in order to implement a reduced weight and flexibility. Specific examples of the resin film have been described above.
The thickness of the base film is not particularly limited, but is normally 5 to 1000 μm, and preferably 10 to 300 μm.

The total thickness of the laminate according to one embodiment of the invention may be appropriately determined depending on the application of the resulting electronic device and the like.

FIGS. 1 and 2 show examples of the layer configuration of the laminate according to one embodiment of the invention. Note that the laminate according to one embodiment of the invention is not limited to the examples shown in FIGS. 1 and 2.

In FIG. 1, S indicates the base film, A1 and A2 indicate the layer A, and B1 and B2 indicate the layer B.
FIGS. 1(a) and 1(b) show a three-layer laminate that includes one layer A, one layer B, and one base film, FIGS. 1(c) and 1(d) show a four-layer laminate that includes two layers A, one layer B, and one base film, and FIGS. 1(e) and 1(f) show a five-layer laminate that includes two layers A, two layers B, and one base film.
Among these, the laminates shown in FIGS. 1(a), 1(c), and 1(e) are preferable from the viewpoint of excellent adhesion to the base film, and the laminate shown in FIG. 1(a) is particularly preferable from the viewpoint of ease of production. Moreover, elevations and depressions on the surface of the base film are reduced by forming the layer A on the base film, so that the layer B can be formed on a flat surface.

In FIG. 2, S, S1, and S2 respectively indicate the base film, a first base film, and a second base film, A indicates the layer A, B indicates the layer B, and C indicates the layer C.
FIGS. 2(a), 2(b), and 2(c) show a four-layer laminate that includes one layer A, one layer B, one layer C, and one base film, FIGS. 2(d) and 2(e) show a five-layer laminate that includes one layer A, one layer B, one layer C, and two base films, and FIG. 2(f) shows a six-layer laminate that includes one layer A, one layer B, two layers C, and two base films.

(Production of laminate)

The laminate according to one embodiment of the invention may be produced by an arbitrary method.
For example, the laminate according to one embodiment of the invention may be produced by (i) implanting ions or the like into a polyorganosiloxane compound-containing film (polyorganosiloxane layer) to form a layer A, and forming a layer B on the layer A, (ii) forming a polyorganosiloxane compound-containing layer on a base film, implanting ions or the like into the surface of the polyorganosiloxane compound-containing layer to form a layer A, and forming a layer B on the layer A, or (iii) forming a layer B on a base film, forming a polyorganosiloxane compound-containing layer on the

layer B, and implanting ions or the like into the surface of the polyorganosiloxane compound-containing layer to form a layer A.

Among these, the methods (ii) and (iii) are preferable from the viewpoint of production efficiency. According to these methods, it is possible to continuously produce a long laminate film. For example, the method (ii) may be implemented as follows.

Specifically, a polyorganosiloxane layer is formed on one side of a long base film. For example, the polyorganosiloxane layer may be formed by applying a solution that includes at least one polyorganosiloxane compound, an optional component, and a solvent to one side of a long base film using a coating apparatus while transferring the base film in a given direction, and optionally heating (drying) the resulting film. The laminate in which the polyorganosiloxane layer is formed on the base film is hereinafter referred to as "laminate film".

The polyorganosiloxane layer of the laminate film is then subjected to plasma ion implantation using a plasma ion implantation apparatus.

FIG. 3 is a view schematically showing a continuous plasma ion implantation apparatus that includes the plasma ion implantation apparatus.

In FIG. 3(a), 11a indicates a chamber, 20a indicates a turbo-molecular pump, 3a indicates a feed roll around which a laminate film 1a is wound before ion implantation, 5a indicates a wind-up roll around which an ion-implanted laminate film 1b is wound, 2a indicates a high-voltage rotary can, 10a indicates a gas inlet, 7 indicates a high-voltage pulse power supply, and 4 indicates a plasma discharge electrode (external electric field). FIG. 3(b) is a perspective view showing the high-voltage rotary can 2a, in which 15 indicates a high-voltage application terminal (feed-through).

In the continuous plasma ion implantation apparatus shown in FIG. 3, the laminate film 1a is transferred from the feed roll 3a in an arrow direction X inside the chamber 11a, passes through the high-voltage rotary can 2a, and is wound around the wind-up roll 5a. The laminate film 1a may be wound and transferred by an arbitrary method. In this embodiment, the laminate film 1a is transferred by rotating the high-voltage rotary can 2a at a constant speed. The high-voltage rotary can 2a is rotated by rotating a center shaft 13 of the high-voltage application terminal 15 using a motor.

The high-voltage application terminal 15, transfer rolls 6a that come in contact with the laminate film 1a, and the like are formed of an insulator. For example, the high-voltage application terminal 15, the transfer rolls 6a, and the like are formed by coating the surface of alumina with a resin (e.g., polytetrafluoroethylene). The high-voltage rotary can 2a is formed of a conductor (e.g., stainless steel).

The transfer speed of the laminate film 1a may be appropriately set. The transfer speed of the laminate film 1a is not particularly limited insofar as ions are implanted into the polyorganosiloxane layer of the laminate film 1a so that the desired implanted layer is formed when the laminate film 1a is transferred from the feed roll 3a and wound around the wind-up roll 5a. The winding speed (line speed) of the ion-implanted laminate film 1b is determined depending on the applied voltage, the size of the apparatus, and the like, but is normally 0.1 to 2 m/min, and preferably 0.2 to 0.7 m/min.

When implanting ions, the pressure inside the chamber 11 a is reduced by discharging air from the chamber 11 a using the turbo-molecular pump 20a connected to a rotary pump. The degree of decompression is normally $1\times10^{-4}$ to 1 Pa, and preferably $1\times10^{-3}$ to $1\times10^{-2}$ Pa.

An ion implantation gas (e.g., nitrogen) is then introduced into the chamber 11a through the gas inlet 10a so that the chamber 11 a is filled with the ion implantation gas under reduced pressure.

Plasma is then generated using the plasma discharge electrode 4 (external electric field). The plasma may be generated using a known method (e.g., microwave or RF high-frequency power supply).

A negative high-voltage pulse 9 is applied from the high-voltage pulse power supply 7 connected to the high-voltage rotary can 2a through the high-voltage application terminal 15, When the negative high-voltage pulse is applied to the high-voltage rotary can 2a, ions present in the plasma are attracted, and implanted into the surface of the polyorganosiloxane layer of the laminate film 1a around the high-voltage rotary can 2a (arrow Y in FIG. 3(a)). The laminate film 1b in which a layer A is formed on the base film is thus obtained.

Note that the plasma ion implantation apparatus may implant ions present in plasma generated by applying a high-voltage pulse without using an external electric field.

A layer B is then formed by magnetron sputtering on the layer A of the laminate film 1b (i.e., the side where the ion-implanted layer is formed).

The layer B may be formed using a continuous magnetron sputtering apparatus shown in FIG. 4, for example.

In the continuous magnetron sputtering apparatus shown in FIG. 4, 11b indicates a chamber, 20b indicates a turbo-molecular pump, 3b indicates a feed roll that feeds the laminate film 1b, 5b indicates a wind-up roll around which a laminate film 1 including a layer B is wound, 10b indicates a gas inlet, 2b indicates a rotary can, 6b indicates a transfer roll, and C indicates a target.

FIGS. 4(b) and 4(c) show the details of the target C. FIG. 4(b) is a cross-sectional view, and FIG. 4(c) is a top view. In FIG. 4(b), 8 indicates a target, and 12 indicates a magnetic field-generating means. In FIG. 4(c), 12a indicates a doughnut-shaped permanent magnet, and 12b indicates a rod-shaped permanent magnet.

The laminate film 1b is transferred from the feed roll 3b in an arrow direction X by rotating the rotary can 2b,

and wound around the wind-up roll 5b.

The laminate film 1b is placed in the chamber 11b so that the layer B is formed on the layer A, and air is discharged from the chamber 11b (i.e., the pressure inside the chamber 11b is reduced) using the turbo-molecular pump 20b connected to a rotary pump, in the same manner as the plasma ion implantation apparatus shown in FIG. 3.

High-frequency electric power is then applied to the target while introducing argon gas and nitrogen gas, for example, into the chamber 11b through the gas inlet 10b, so that a plasma discharge occurs. The argon gas and the nitrogen gas are thus ionized, and collide against the target. The atoms (e.g., Si) that form the target are released as sputter particles due to the impact, and are deposited on the surface of the layer A of the laminate film 1b. A magnetic field formed by the magnetic field-generating means 12 causes secondary electrons released from the target to make a cycloidal motion, so that the frequency of ionization collision against the nitrogen gas and the like is increased. Therefore, plasma is generated around the target, so that the deposition rate increases.

The laminate 1 in which the layer B (silicon nitride film) is formed on the layer A of the laminate film 1b is thus obtained. A layer of another inorganic compound may be formed as the layer B in the same manner as described above.

A laminate having a layer configuration shown in FIG. 2 (e.g., the laminate shown in FIG. 2(a)) may be produced by forming a polyorganosiloxane layer on the base film S, implanting ions into the surface of the polyorganosiloxane layer to form the layer A, forming the layer B on the layer A, and forming the layer C on the layer B. According to this method, it is possible to continuously produce a long laminate. A method of producing the laminate shown in FIG. 2(a) is described in detail below.

Specifically, a polyorganosiloxane layer is formed on one side of the long first base film, and subjected to plasma ion implantation using the plasma ion implantation apparatus by the same method as the method of producing the laminate having the layer configuration shown in FIG. 1.

The layer B is then formed on the layer A of the laminate film 1b (i.e., the side where the ion-implanted layer is formed).

The layer B may be formed using the continuous magnetron sputtering apparatus shown in FIG. 4, for example.

A laminate film 1d in which the layer B is formed on the layer A of the laminate film 1b is thus formed.

The layer C is then formed on the layer B of the laminate film 1d.

A solution for forming the impact-absorbing layer is applied to the long second base film (S2), and the resulting film is dried/heated to form the layer C on the second base film S2. The resulting laminate is stacked on the layer B so that the layer C comes in contact with the layer B. The laminate shown in FIG. 2(d) is thus obtained. The laminate shown in FIG. 2(a) can be obtained by removing a release film used as the second base film S2 from the above laminate.

The laminate shown in FIG. 2(e) can be obtained by forming the layer C on the first base film S1, sequentially stacking the layer B and the layer A on the second base film S2, and stacking the laminates so that the layer C comes in contact with the layer A formed on the base film S2, The laminate shown in FIG. 2(b) can be obtained by removing the base film S 1 from the resulting laminate.

The laminate shown in FIG. 2(c) can be obtained by sequentially stacking the layers C, A, and B on the base film S. The laminate shown in FIG. 2(f) can be obtained by sequentially stacking the layers C, A, and B on the first base film S 1, forming the layer C on the second base film S2, and stacking the laminates so that the layer B comes in contact with the layer C formed on the base film S2.

The laminate according to one embodiment of the invention exhibits an excellent gas barrier capability, excellent transparency, and excellent folding resistance (i.e., the laminate can be easily folded (bent) without causing cracks).

The laminate according to one embodiment of the invention exhibits an excellent gas barrier capability since the laminate has a significantly low gas (e.g., water vapor) permeability as compared with an inorganic compound layer or the like having an identical thickness. For example, the water vapor permeability of the laminate at a temperature of 40°C and a relative humidity of 90% is preferably 0.2 $g/m^2$/day or less, and more preferably 0.1 $g/m^2$/day or less. The gas (e.g., water vapor) permeability of the laminate may be measured using a know gas permeability measuring device.

The transparency of the laminate according to one embodiment of the invention may be evaluated by measuring the visible light transmittance of the laminate. The visible light transmittance (total light transmittance) of the laminate is preferably 80% or more, and more preferably 85% or more. The visible light transmittance of the laminate may be measured using a known visible light transmittance measuring device.

Whether or not the laminate according to one embodiment of the invention exhibits excellent folding resistance may be determined by winding the laminate around a stainless steel rod having a diameter of 3 mm so that the layer B comes in contact with the rod, moving the laminate upward and downward ten times, observing the layer B using an optical microscope (magnification: 2000), and determining the presence or absence of cracks.

When the laminate according to one embodiment of the invention includes the impact-absorbing layer, the laminate according to one embodiment of the invention exhibits an excellent impact-absorbing capability (impact resistance) in addition to the excellent gas barrier capability, excellent transparency, and excellent folding resistance (i.e., the laminate can be easily folded (bent) without causing cracks).

Whether or not the laminate according to one embodiment of the invention exhibits an excellent impact-absorbing capability may be determined by placing the laminate on a support formed of stainless steel or the like so that the impact-absorbing layer is positioned on the upper side, dropping an iron ball having a diameter of 1 cm and a weight of 5 g onto the laminate from a height of 30 cm, observing the surface state of the inorganic compound layer using an optical microscope (magnification: 100), and determining the presence or absence of cracks.

Since the laminate according to one embodiment of the invention also exhibits excellent flexibility, the laminate may suitably be used for a solar cell back-side protective sheet, a touch panel, a flexible display, and the like.

2) Electronic device member and electronic device

An electronic device member according to one embodiment of the invention includes the laminate according to one embodiment of the invention. Therefore, since the electronic device member according to one embodiment of the invention exhibits an excellent gas barrier capability, a deterioration in the element (member) due to gas (e.g., water vapor) can be prevented. Moreover, since the electronic device member exhibits an excellent impact-absorbing capability, the electronic device member may suitably be used as a display member for liquid crystal displays, electroluminescence displays, and the like; a solar cell back-side protective sheet; and the like.

When using the laminate according to one embodiment of the invention as an electronic device member, the impact-absorbing layer is disposed on the outer side of the electronic device, and the inorganic compound layer is disposed on the inner side of the impact-absorbing layer. When the inorganic compound layer is disposed between two impact-absorbing layers (see FIG. 2(f)), an arbitrary impact-absorbing layer may be disposed on the outer side.

An electronic device according to one embodiment of the invention includes the electronic device member according to one embodiment of the invention. Specific examples of the electronic device include a liquid crystal display, an organic EL display, an inorganic EL display, electronic paper, a solar cell, and the like.

Since the electronic device according to one embodiment of the invention includes the electronic device member that includes the laminate according to one embodiment of the invention, the electronic device exhibits an excellent gas barrier capability, excellent transparency, and excellent flexibility, and can be reduced in weight.

EXAMPLES

The invention is further described below by way of examples. Note that the invention is not limited to the following examples.

A plasma ion implantation apparatus, an X-ray photoelectron spectroscopy (XPS) measuring device, an X-ray photoelectron spectroscopy (XPS) measuring method, a sputtering apparatus, a water vapor permeability measuring device, a water vapor permeability measuring method, a visible light transmittance measuring device, a folding test method, a measuring device for a storage modulus of an impact-absorbing layer, a measuring method for a storage modulus of an impact-absorbing layer, an impact-absorbing layer Young's modulus measuring method, and an impact-absorbing capability test used in the examples are as follows.

Whether or not an ion-implanted layer was formed was determined by performing elemental analysis in an area of about 10 nm from the surface of the layer A using an XPS measuring device ("Quantum 2000" manufactured by ULVAC-PHI, Incorporated).

(Plasma ion implantation apparatus)

RF power supply: "RF56000" manufactured by JEOL Ltd.
High-voltage pulse power supply: "PV-3-HSHV-0835" manufactured by Kurita Seisakusho Co., Ltd.

(X-ray photoelectron spectroscopy measuring device)

Measuring device: "PHI Quantera SXM" manufactured by ULVAC-PHI, Incorporated X-ray beam diameter: 100 μm
Electric power: 25 W
Voltage: 15 kV
Take-off angle: 45°

The oxygen atom content rate, the carbon atom content rate, the silicon atom content rate, and the silicon atom 2p electron binding energy peak position were measured as follows under the above conditions.

In Examples 1 to 3, 7, and 8, the oxygen atom content rate, the carbon atom content rate, the silicon atom content rate, and the silicon atom 2p electron binding energy peak position in the surface of the polydimethylsiloxane-containing layer subjected to plasma ion implantation were measured to determine the oxygen atom content rate, the carbon atom content rate, the silicon atom content rate, and the silicon atom 2p electron binding energy peak position in the surface layer part of the gas barrier layer. The plasma ion-implanted surface was subjected to sputtering using argon gas in the depth direction, and the oxygen atom content rate, the carbon atom content rate, and the silicon atom content rate in the surface exposed by sputtering were measured. This operation was repeated to determine the oxygen atom content rate, the carbon atom content rate, and the silicon atom content rate in the depth direction.

The applied voltage during sputtering using argon gas was -4 kV. The sputtering time was 12 seconds. The oxygen atom content rate, the carbon atom content rate, and the silicon atom content rate were calculated from the peak area of each atom with respect to the total peak area (=100%) of oxygen atoms, carbon atoms, and silicon atoms.

(Sputtering apparatus)

"RS-0549" manufactured by Rock Giken Kogyo Co., Ltd.

(Water vapor permeability measuring device)

"L80-5000" manufactured by LYSSY
Relative humidity: 90%, temperature: 40°C

(Visible light transmittance measuring device)

"UV-3101PC" manufactured by Shimadzu Corporation

The visible light transmittance at a wavelength of 550 nm was measured.

(Folding resistance test)

The laminate (Examples 1 to 6 and Comparative Example 1) was wound around a stainless steel rod having a diameter of 3 mm so that the layer B came in contact with the rod, and moved upward and downward ten times. The layer B was observed using an optical microscope (manufactured by Keyence Corporation) (magnification: 2000), and the presence or absence of cracks in the layer B was determined.

(Measuring device/method for a storage modulus of an impact-absorbing layer)

A solution for forming the impact-absorbing layer (Examples 7 to 10) was applied to a release film ("PET3 801" manufactured by LINTEC Corporation), and dried to form a layer having a thickness of 30 μm. This layer was stacked to prepare a measurement specimen having a thickness of 3 mm and a diameter of 8 mm. The storage modulus (Pa) (25°C) of the measurement specimen was measured using a viscoelasticity analyzer ("DYNAMIC ANALYZER RDA II" manufactured by REOMETRIC). The measurement frequency was 1 Hz, and the temperature increase rate was 3°C/min.

(Measuring method for a Young's modulus of an impact-absorbing layer)

The Young's modulus of the impact-absorbing layer was measured in accordance with JIS K 7161:1994 and JIS K 7127:1999. A label for pulling a specimen was attached to an area of 20 mm on each end of the specimen (width: 15 mm, length: 140 mm, the release sheet was removed) to obtain a dumbbell-shaped sample (width: 15 mm, length: 100 mm). The Young's modulus was measured at a tensile rate of 200 mm/min using a universal tester ("Autograph AG-IS500N" manufactured by Shimadzu Corporation) utilizing the dumbbell-shaped sample.

(Impact-absorbing capability test)

The laminate (Examples 7 to 11) was placed on a support (SUS sheet) so that the impact-absorbing layer was positioned on the upper side. An iron ball having a diameter of 1 cm and a weight of 5 g was dropped onto the laminate from a height of 30 cm. The surface state of the inorganic compound layer was then observed using an optical microscope (manufactured by Keyence Corporation) (magnification: 100), A case where cracks were not observed in the inorganic compound layer was evaluated as "Good", and a case where cracks were observed in the inorganic compound layer was evaluated as "Bad".

(Example 1)

A silicone resin ("K835" manufactured by Shin-Etsu Chemical Co., Ltd.) containing a polydimethylsiloxane as the main component (polyorganosiloxane compound) was applied to a polyethylene terephthalate film (PET film) ("PET38T-300" manufactured by Mitsubishi Plastics, Inc., thickness: 38 μm) (base film). The silicone resin was heated at 120°C for 2 minutes to form a polydimethylsiloxane-containing layer (thickness: 100 nm) on the PET film. Argon ions were implanted into the surface of the polydimethylsiloxane-containing layer using the plasma ion implantation apparatus shown in FIG. 3. It was confirmed by XPS that argon was present in an area of about 10 nm from the surface of the polydimethylsiloxane-containing layer.

The following plasma ion implantation conditions were used.

Plasma-generating gas: argon
Duty ratio: 0.5%
Repetition frequency: 1000 Hz
Applied voltage: -10 kV
RF power supply: frequency: 13.56 MHz, power: 1000 W
Chamber internal pressure: 0.2 Pa
Pulse width: 5 μs
Line speed: 0.4 m/min
Processing time (ion implantation time): 5 minutes

A silicon nitride ($Si_3N_4$) layer (thickness: 50 nm) was formed on the ion-implanted silicone resin layer by magnetron sputtering using the winding type sputtering apparatus to obtain a laminate 1 including a base (PET film), a layer A (argon ion-implanted silicone resin layer), and a layer B (silicon nitride layer).

The following magnetron sputtering conditions were used.

Plasma-generating gas: argon and nitrogen
Gas flow rate: argon: 100 seen, nitrogen: 60 sccm
Electric power: 2500 W
Chamber internal pressure: 0.2 Pa
Line speed: 0.2 m/min
Processing time: 10 minutes
Target: Si

(Example 2)

A laminate 2 was obtained in the same manner as in Example 1, except for using nitrogen as the plasma-generating gas instead of argon during plasma ion implantation.

(Example 3)

A laminate 3 was obtained in the same manner as in Example 1, except for using helium as the plasma-generating gas instead of argon during plasma ion implantation.

(Comparative Example 1)

A laminate A including a base (PET film) and a layer B (silicon nitride layer) was obtained in the same manner as in Example 1, except for forming a silicon nitride layer (layer B) on the PET film without forming the silicone resin layer, and omitting plasma ion implantation.

Table 1 shows the measurement results for the oxygen atom content rate, the carbon atom content rate, the silicon atom content rate, and the silicon atom 2p electron binding energy peak position in the surface layer part of the gas barrier layer (i.e., an area where the oxygen atom content rate gradually decreases and the carbon atom content rate gradually increases from the surface in the depth direction) of the laminates 1 to 3 of Examples 1 to 3.

TABLE 1

| | Laminate | Content rate | | | Peak position (eV) |
|---|---|---|---|---|---|
| | | Oxygen atom (%) | Carbon atom (%) | Silicon atom (%) | |
| Example 1 | 1 | 49.7 | 27.4 | 22.9 | 103.3 |
| Example 2 | 2 | 59.6 | 17.5 | 22.9 | 103.0 |
| Example 3 | 3 | 52.9 | 26.5 | 20.6 | 103.1 |

As shown in Table 1, the laminates 1 to 3 had a silicon atom 2p electron binding energy peak position of 103.0 to 103.3 eV.

FIGS. 5 to 7 show the XPS elemental analysis results for the oxygen atom content rate, the carbon atom content rate, and the silicon atom content rate of the laminates 1 to 3 of Examples 1 to 3. FIG. 5 shows the results for the laminate 1, FIG. 6 shows the results for the laminate 2, and FIG. 7 shows the results for the laminate 3. FIG. 8 show the XPS elemental analysis results for the oxygen atom content rate, the carbon atom content rate, and the silicon atom content rate in the polydimethylsiloxane-containing layer before plasma ion implantation.

In FIGS. 5 to 8, the vertical axis indicates the oxygen atom content rate (%), the carbon atom content rate (%), and the silicon atom content rate (%) based on the total content (=100%) of oxygen atoms, carbon atoms, and silicon atoms, and the horizontal axis indicates the cumulative sputtering time (Sputter time (min)). Since the sputtering rate was constant, the cumulative sputtering time (Sputter time) corresponds to the depth.

In FIGS. 5 to 8, a indicates the carbon atom content rate, b indicates the oxygen atom content rate, and c indicates the silicon atom content rate.

As shown in FIGS. 5 to 7, it was confirmed that the laminates 1 to 3 had an area (gas barrier layer) where the oxygen atom content rate gradually decreases and the carbon atom content rate gradually increases from the surface in the depth direction.

As shown in FIG. 8, the polydimethylsiloxane-containing layer before plasma ion implantation did not have the above area (gas barrier layer).

FIG. 9 shows the XPS analysis results for the silicon atom 2p electron binding energy in the surface layer part of the gas barrier layer (hereinafter referred to as "gas barrier layer 1") of the laminate 1 of Example 1. In FIG. 9, the vertical axis indicates the peak intensity, and the horizontal axis indicates the binding energy (eV). As shown in FIG. 9, the gas barrier layer 1 had a silicon atom 2p electron binding energy peak position (B) of 103.3 eV. The silicon atom 2p electron binding energy peak position of the gas barrier layer 1 was 101.5 eV before ion implantation, and shifted to the high energy side (103.3 eV) due to ion implantation.

(Example 4)

A silicon oxide ($SiO_2$) layer (thickness: 50 nm) was formed on the ion-implanted silicone resin layer by magnetron sputtering using the winding type sputtering apparatus in the same manner as in Example 1 to obtain a laminate 4 including a base (PET film), a layer A (argon ion-implanted silicone resin layer), and a layer B (silicon oxide layer).

The following magnetron sputtering conditions were used.

Plasma-generating gas: argon and oxygen
Gas flow rate: argon: 100 sccm, oxygen: 60 seem
Electric power: 2000 W
Chamber internal pressure: 0.2 Pa
Line speed: 0.2 m/min
Processing time: 10 minutes
Target: Si

(Example 5)

A silicon oxynitride (SiOxNy) layer (thickness: 50 nm) was formed on the ion-implanted silicone resin layer by magnetron sputtering using the winding type sputtering apparatus in the same manner as in Example 1 to obtain a laminate 5 including a base (PET film), a layer A (argon ion-implanted silicone resin layer), and a layer B (silicon oxynitride layer).

The following magnetron sputtering conditions were used.

Plasma-generating gas: argon and oxygen
Gas flow rate: argon: 100 sccm, oxygen: 30 sccm, nitrogen: 30 sccm
Electric power: 2500 W
Chamber internal pressure: 0.2 Pa
Line speed: 0.2 m/min
Processing time: 10 minutes
Target: Si

(Example 6)

An aluminum oxide ($Al_2O_3$) layer (thickness: 50 nm) was formed on the ion-implanted silicone resin layer by magnetron sputtering using the winding type sputtering apparatus in the same manner as in Example 1 to obtain a laminate 6 including a base (PET film), a layer A (argon ion-implanted silicone resin layer), and a layer B (aluminum oxide layer).

The following magnetron sputtering conditions were used.

Plasma-generating gas: argon and oxygen
Gas flow rate: argon: 100 sccm, oxygen: 60 sccm
Electric power: 2500 W
Chamber internal pressure: 0.2 Pa
Line speed: 0.2 m/min
Processing time: 10 minutes
Target: A1

The water vapor permeability and the total light transmittance of the laminates 1 to 6 and A of Examples 1 to 6 and Comparative Example 1 were measured using the water vapor permeability measuring device and the visible light transmittance measuring device. The measurement results are shown in Table 2. The presence or absence of cracks was determined after the folding resistance test. The results are also shown in Table 2.

TABLE 2

| | Laminate | Water vapor permeability ($g/m^2/day$) | Total light transmittance (%) | Cracks |
|---|---|---|---|---|
| Example 1 | 1 | 0.04 | 74.8 | None |
| Example 2 | 2 | 0.08 | 75.5 | None |
| Example 3 | 3 | 0.05 | 73.0 | None |
| Example 4 | 4 | 0.06 | 75.8 | None |
| Example 5 | 5 | 0.05 | 75.0 | None |
| Example 6 | 6 | 0.07 | 75.1 | None |
| Comparative Example 1 | A | 0.55 | 79.1 | Observed |

As shown in Table 2, the laminates 1 to 6 of Examples 1 to 6 exhibited low water vapor permeability and an excellent gas barrier capability as compared with the laminate A of Comparative Example 1. The laminates 1 to 6 had a total light transmittance of 70% or more. Moreover, cracks were not observed in the laminates 1 to 6 after the folding resistance test. It was thus confirmed that the laminates 1 to 6 had excellent folding resistance as compared with the laminate A.

(Example 7)

(i) Formation of polyorganosiloxane layer having ion-implanted layer

A silicone release agent ("KS835" manufactured by Shin-Etsu Chemical Co., Ltd.) containing a polydimethylsiloxane as the main component (polyorganosiloxane compound) was applied to a polyethylene terephthalate film (PET film) ("T- 100" manufactured by Mitsubishi Plastics, Inc., thickness: 38 μm) (base film). The silicone release agent was heated at 120°C for 2 minutes to form a polydimethylsiloxane-containing layer (thickness: 100 nm) on the PET film. A laminate film was thus obtained. Argon ions were implanted into the surface of the polydimethylsiloxane-containing layer using the plasma ion implantation apparatus shown in FIG. 3 to form a polyorganosiloxane layer having an ion-implanted layer (hereinafter referred to as "polyorganosiloxane compound layer").

The following plasma ion implantation conditions were used.

Duty ratio: 1%
Repetition frequency: 1000 Hz
Applied voltage: -10 kV
RF power supply: frequency: 13.56 MHz, applied electric power: 1000 W
Chamber internal pressure: 0.2 Pa
Pulse width: 5 μs
Line speed: 0.4 m/min
Processing time (ion implantation time): 5 minutes
Gas flow rate: 100 ccm

Whether or not an ion-implanted layer was formed was determined by performing elemental analysis in an area of about 10 nm from the surface of the layer A using an XPS measuring device ("Quantum 2000" manufactured by ULVAC-PHI, Incorporated).
The laminate film had a water vapor permeability of 0.3 g/m$^2$/day.

(ii) Formation of inorganic compound layer

A silicon nitride ($Si_3N_4$) film (thickness: 50 nm) (hereinafter referred to as "inorganic compound layer 7") was formed by sputtering on the argon ion-implanted polyorganosiloxane layer (hereinafter referred to as "polyorganosiloxane compound layer 7").

The following sputtering conditions were used.

Plasma-generating gas: argon and nitrogen
Gas flow rate: argon: 100 sccm, nitrogen: 60 sccm
Electric power: 2500 W
Chamber internal pressure: 0.2 Pa
Line speed: 0.2 m/min
Processing time: 10 minutes
Thickness: 50 nm
Target: Si

(iii) Formation of impact-absorbing layer

100 parts by mass (solid content) of a solution of an acrylate copolymer (pressure-sensitive adhesive) of 2-ethylhexyl acrylate and acrylic acid (2-ethylhexyl acrylate:acrylic acid=95:5 (weight ratio)) was mixed with 0.1 parts by mass (solid content) of trimethylolpropane tolylene diisocyanate ("Coronate L" manufactured by Nippon Polyurethane Industry Co., Ltd.) to prepare a pressure-sensitive adhesive solution A. The solution A was applied to a release sheet ("SP-PET3 801" manufactured by LINTEC Corporation), and heated at 120°C for 2 minutes to form an impact-absorbing layer 7 (thickness: 30 μm) on the release sheet.

The impact-absorbing layer 7 was stacked on the surface of the inorganic compound layer 7. The release sheet was then removed to obtained a laminate 7 including the PET film, the polyorganosiloxane compound layer 7, the inorganic compound layer 7, and the impact-absorbing layer 7. It was confirmed by XPS elemental analysis that the polyorganosiloxane compound layer 7 had an area (gas barrier layer) where the oxygen atom content rate gradually decreases and the carbon atom content rate gradually increases from the surface (ion implantation surface) in the depth direction. Table 3 shows the oxygen atom content rate, the carbon atom content rate, the silicon atom content rate, and

the silicon atom 2p electron binding energy peak position in the surface layer part of the gas barrier layer.

(Example 8)

A laminate 8 was obtained in the same manner as in Example 7, except for using nitrogen as the plasma-generating gas instead of argon during plasma ion implantation. It was confirmed by XPS elemental analysis that the plasma ion-implanted polyorganosiloxane compound layer of the laminate 8 had an area (gas barrier layer) where the oxygen atom content rate gradually decreases and the carbon atom content rate gradually increases from the surface (ion implantation surface) in the depth direction. Table 3 shows the oxygen atom content rate, the carbon atom content rate, the silicon atom content rate, and the silicon atom 2p electron binding energy peak position in the surface layer part of the gas barrier layer.
TABLE 3

| | Laminate | Content | | | Peak position (eV) |
|---|---|---|---|---|---|
| | | Oxygen atom (%) | Carbon atom (%) | Silicon atom (%) | |
| Example 7 | 7 | 49.8 | 27.3 | 22.9 | 103.3 |
| Example 8 | 8 | 59.8 | 17.4 | 22.8 | 103.0 |

(Example 9)

A laminate 9 was obtained in the same manner as in Example 7, except for forming an impact-absorbing layer 9 (thickness: 40 μm) instead of the impact-absorbing layer 7 using a rubber pressure-sensitive adhesive("TN-286" manufactured by Matsumura Oil Co., Ltd.) instead of the pressure-sensitive adhesive solution A.

(Example 10)

A laminate 10 was obtained in the same manner as in Example 7, except for using a pressure-sensitive adhesive solution B prepared by mixing 100 parts by weight of a silicone pressure-sensitive adhesive ("S-4580" manufactured by Dow Corning Toray Co., Ltd.) and 0.9 parts by weight of a platinum catalyst ("SRX-212" manufactured by Dow Corning Toray Co., Ltd.) instead of the pressure-sensitive adhesive solution A, applying the solution B to a release sheet ("PET50FD" manufactured by LINTEC Corporation), and heating the applied solution at 120°C for 2 minutes to form an impact-absorbing layer 10 (thickness: 30 μm) on the PET film.

(Example 11)

A laminate 11 was obtained in the same manner as in Example 7, except for forming an impact-absorbing layer 11 (thickness: 100 μm) instead of the impact-absorbing layer 7 using a urethane acrylate curable resin.

<Formation of impact-absorbing layer 11>

The impact-absorbing layer 11 was formed as follows.
An isocyanate-terminated urethane prepolymer obtained by reacting a polyester diol with isophorone diisocyanate was reacted with 2-hydroxyethyl acrylate to obtain a urethane acrylate oligomer having a weight average molecular weight of about 5000. 40 parts by weight of the urethane acrylate oligomer, 20 parts by weight of phenylhydroxypropyl acrylate, 40 parts by weight of isobornyl acrylate, and 2.0 parts by weight of 1-hydroxycyclohexyl phenyl ketone ("Irgacure 184" manufactured by Ciba Specialty Chemicals Inc.) (photoinitiator) were mixed to obtain a photocurable resin composition. The resin composition was applied to a release sheet ("SP-PET3801" manufactured by LINTEC Corporation) to a thickness of 100 μm, and cured by applying ultraviolet rays (dose: 200 mJ/$cm^2$) using a high-pressure mercury lamp to form an impact-absorbing layer 11.

(Reference Example 1)

A laminate B was obtained in the same manner as in Example 7, except that the impact-absorbing layer 7 was not formed.

The storage modulus of the impact-absorbing layer, the value "Young's modulus × thickness" obtained from the measurement of the Young's modulus of the impact-absorbing layer, the impact-absorbing capability (presence or absence of cracks in inorganic compound layer), and the water vapor permeability before and after the impact-absorbing capability test were measured using the laminates 7 to 11, the laminate A of Comparative Example 1, and the laminate B of Reference Example 1. The measurement results are shown in Table 4.
TABLE4

| | Laminate | Impact-absorbing layer | | Cracks in inorganic Compound layer | Water vapor permeability ($g/m^2/day$) | |
|---|---|---|---|---|---|---|
| | | Storage modulus (Pa) | Young's modulus × thickness (Pa/cm) | | Before test | After test |
| Example 7 | 7 | $1.3\times10^5$ | 1170 | Good | 0.04 | 0.05 |
| Example 8 | 8 | $1.3\times10^5$ | 1170 | Good | 0.06 | 0.06 |
| Example 9 | 9 | $3.6\times10^4$ | 432 | Good | 0.05 | 0.06 |
| Example 10 | 10 | $8.0\times10^4$ | 720 | Good | 0.04 | 0.08 |
| Example 11 | 11 | - | $2.72\times10^6$ | Good | 0.05 | 0.05 |
| Comparative Example 1 | A | - | - | Bad | 0.55 | 1.00 |
| Reference Example 1 | B | - | - | Bad | 0.04 | 0.51 |

As shown in Table 4, the laminates 7 to 11 of Examples 7 to 11 exhibited low water vapor permeability and an excellent gas barrier capability, did not produce cracks in the inorganic compound layer during the impact-absorbing capability test, did not show a change in water vapor permeability due to the impact-absorbing capability test as compared with the laminate A of Comparative Example 1 and the laminate B of Reference Example 1, and did not show a decrease in gas barrier capability.

## INDUSTRIAL APPLICABILITY

The laminate according to one embodiment of the invention may suitably be used for an electronic device member such as a flexible display member and a solar cell backseat.
The method of producing a laminate according to one embodiment of the invention can safely and conveniently produce the laminate according to one embodiment of the invention that exhibits an excellent gas barrier capability.
Since the electronic device member according to one embodiment of the invention exhibits an excellent gas barrier capability and excellent transparency, the electronic device member may suitably be used for electronic devices such as displays and solar cells.

## EXPLANATION OF SYMBOLS

1a, 1b, 1d: laminate film, 2a, 2b: rotary can, 3a, 3b: feed roll, 4: plasma discharge electrode, 5a, 5b: wind-up roll, 6a, 6b: transfer roll, 7: pulse power supply, 9: high-voltage pulse, 10a, 10b: gas inlet, 11a, 11b: chamber, 13: center shaft, 15: high-voltage application terminal, 20a, 20b: turbo-molecular pump

## Claims

1. A laminate comprising a gas barrier layer and an inorganic compound layer, the gas barrier layer being formed of a material that includes at least an oxygen atom, a carbon atom, and a silicon atom, the gas barrier layer having an oxygen atom content rate that gradually decreases from the surface of the gas barrier layer in the depth direction, and having a carbon atom content rate that gradually increases from the surface of the gas barrier layer in the depth

direction.

**2.** The laminate according to claim 1, wherein the surface layer part of the gas barrier layer has an oxygen atom content rate of 10 to 70%, a carbon atom content rate of 10 to 70%, and a silicon atom content rate of 5 to 35%, based on the total content of oxygen atoms, carbon atoms, and silicon atoms.

**3.** The laminate according to claim 1, wherein the surface layer part of the gas barrier layer has a silicon atom 2p electron binding energy peak position determined by X-ray photoelectron spectroscopy (XPS) of 102 to 104 eV.

**4.** The laminate according to claim 1, further comprising an impact-absorbing layer having a storage modulus at 25°C of $1 \times 10^2$ to $1 \times 10^9$ Pa.

**5.** The laminate according to claim 1, further comprising an impact-absorbing layer that satisfies the following expressions (1) and (2),

$$300\,\mathrm{Pa \cdot cm} < E' \times L < 10^7\,\mathrm{Pa \cdot cm} \quad (1)$$

$$10^{-3}\,\mathrm{cm} < L < 0.05\,\mathrm{cm} \quad (2)$$

where, E' is the Young's modulus (Pa) of the impact-absorbing layer, and L is the thickness (cm) of the impact-absorbing layer.

**6.** The laminate according to claim 1, the laminate having a water vapor permeability at a temperature of 40°C and a relative humidity of 90% of 0.1 g/m$^2$/day or less.

**7.** The laminate according to claim 1, wherein the gas barrier layer is a layer produced by implanting ions into a polyorganosiloxane compound-containing layer.

**8.** The laminate according to claim 7, wherein the ions have been produced by ionizing at least one gas selected from the group consisting of nitrogen, oxygen, argon, and helium.

**9.** The laminate according to claim 7, wherein the polyorganosiloxane compound is a polyorganosiloxane that includes a repeating unit shown by the following formula (a) or (b),

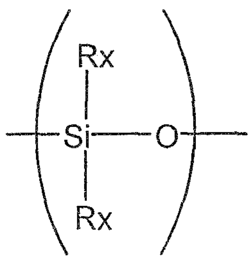

(a)

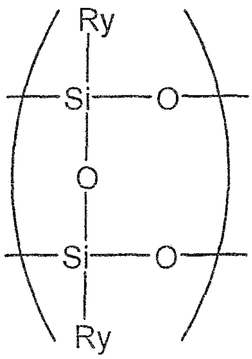

(b)

wherein Rx and Ry individually represent a hydrogen atom or a non-hydrolyzable group such as a substituted or unsubstituted alkyl group, a substituted or unsubstituted alkenyl group, or a substituted or unsubstituted aryl group, and a plurality of Rx in the formula (a) and a plurality of Ry in the formula (b) may respectively be either the same or different, provided that a case where both Rx in the formula (a) represent a hydrogen atom is excluded.

**10.** A method of producing the laminate according to any one of claims 7 to 9, the method comprising implanting ions into a polyorganosiloxane compound-containing layer of a formed article that includes the polyorganosiloxane compound-containing layer in its surface area to form the gas barrier layer.

**11.** The method according to claim 10, wherein the ions are produced by ionizing at least one gas selected from the group consisting of nitrogen, oxygen, argon, and helium,

**12.** The method according to claim 10, wherein the ions are implanted by plasma ion implantation.

**13.** The method according to claim 10, wherein the ions are implanted into the polyorganosiloxane compound-containing layer while transferring a long formed article that includes the polyorganosiloxane compound-containing layer in its surface area in a given direction.

**14.** An electronic device member comprising the laminate according to any one of claims 1 to 9.

**15.** An electronic device comprising the electronic device member according to claim 14.

FIG. 1

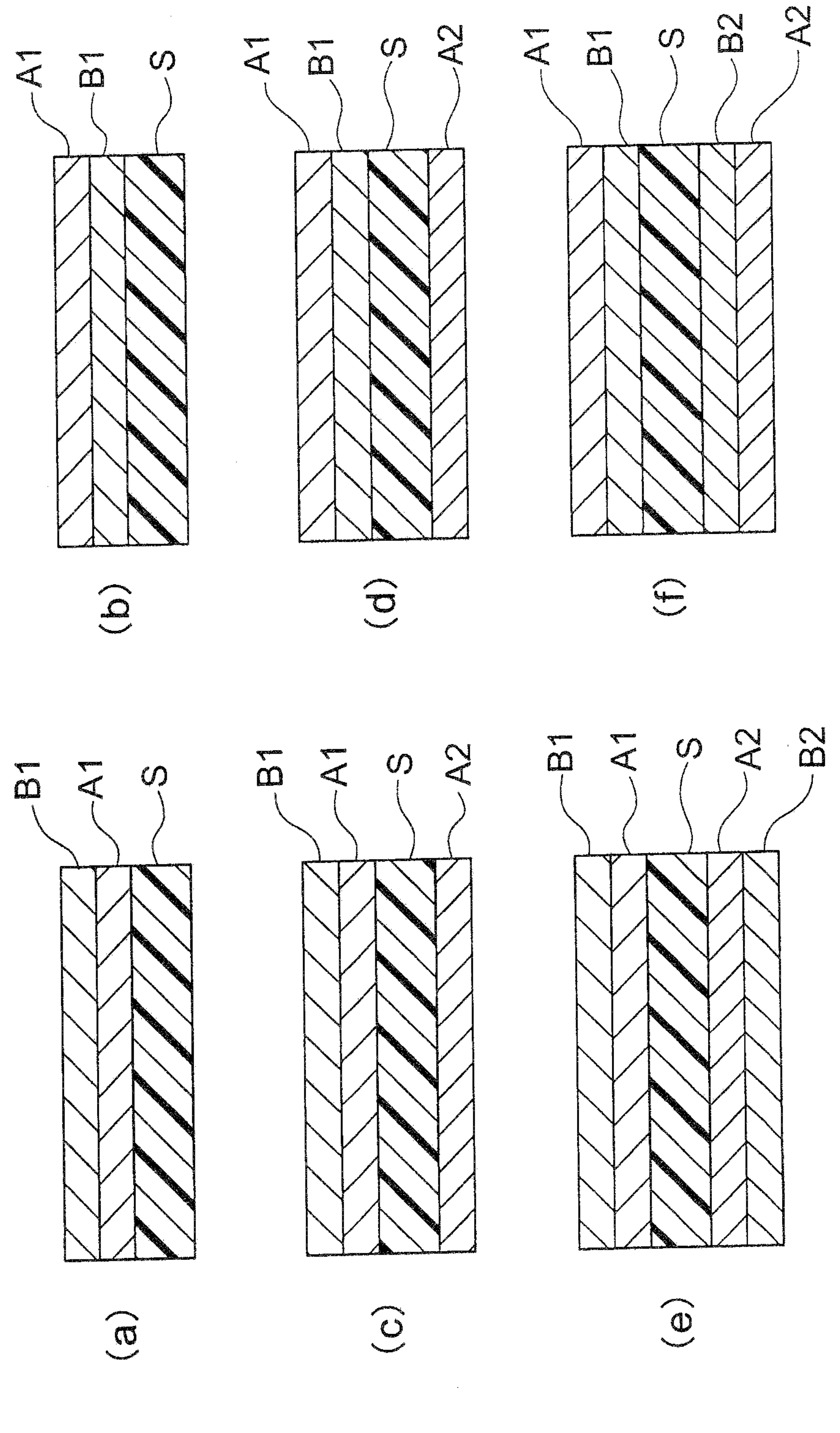

F I G. 2

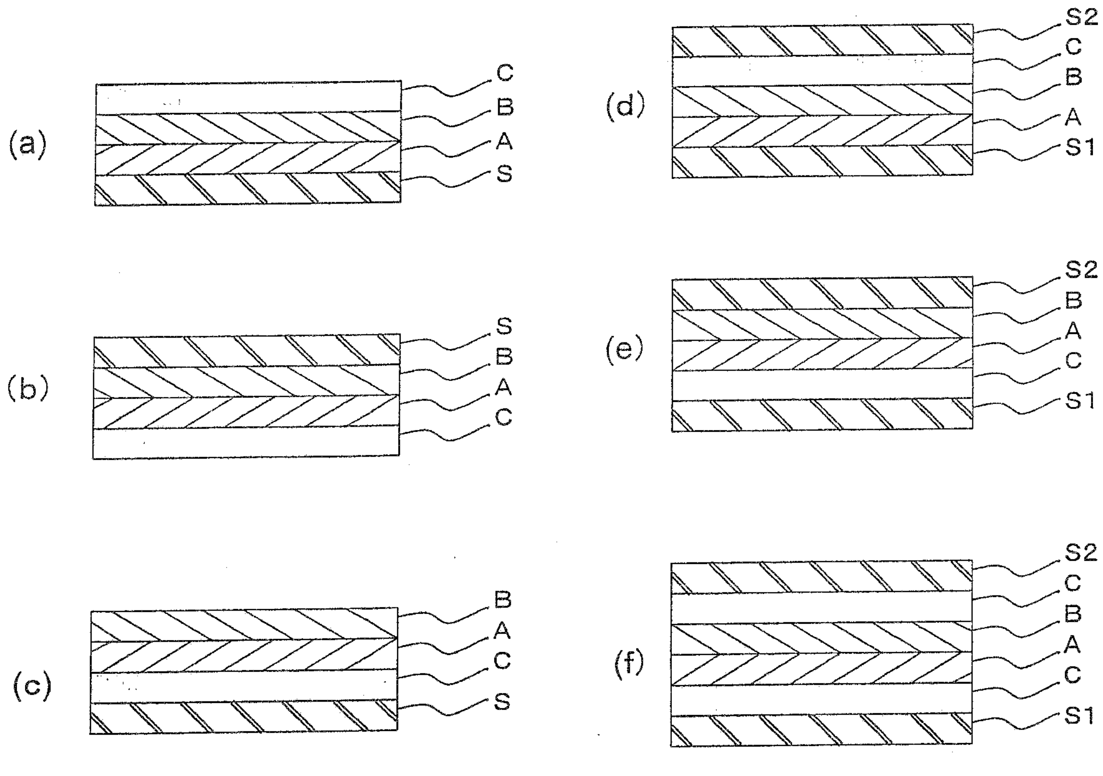

F I G. 3

(a)

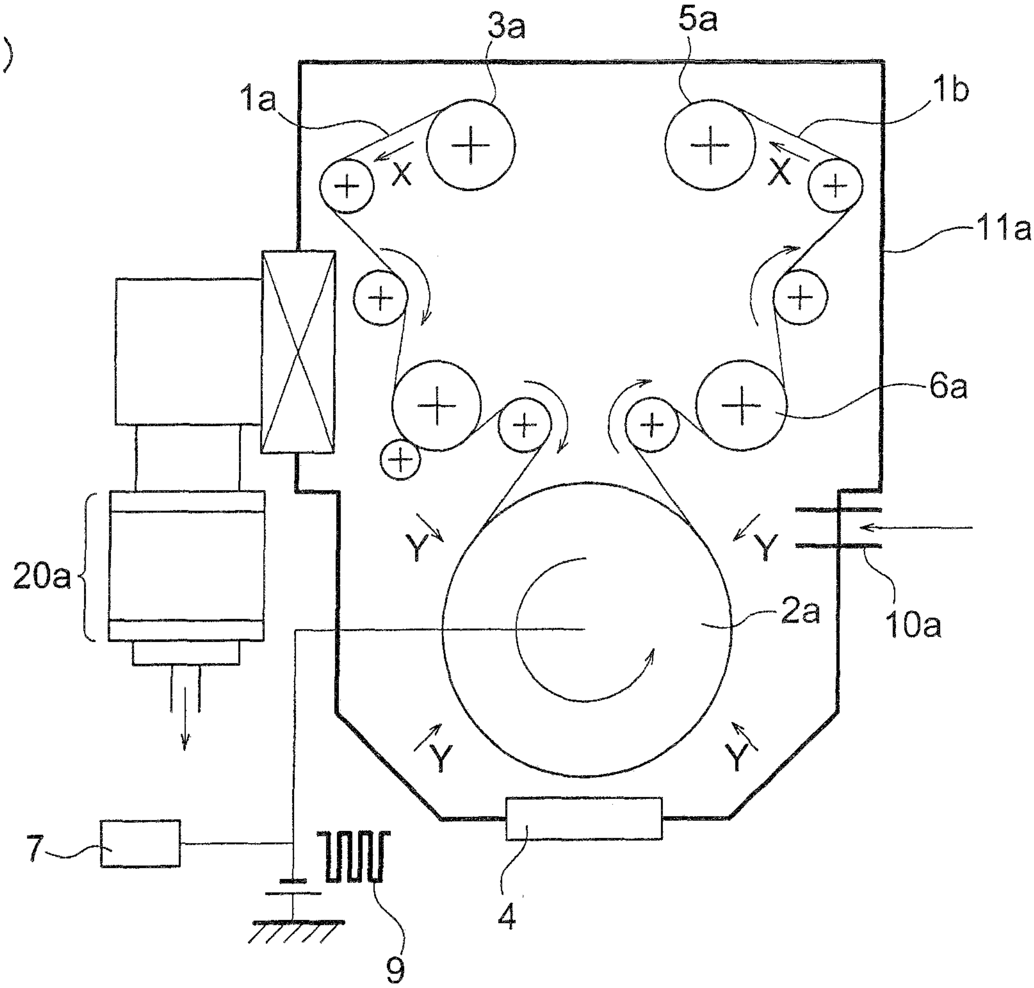


(b)

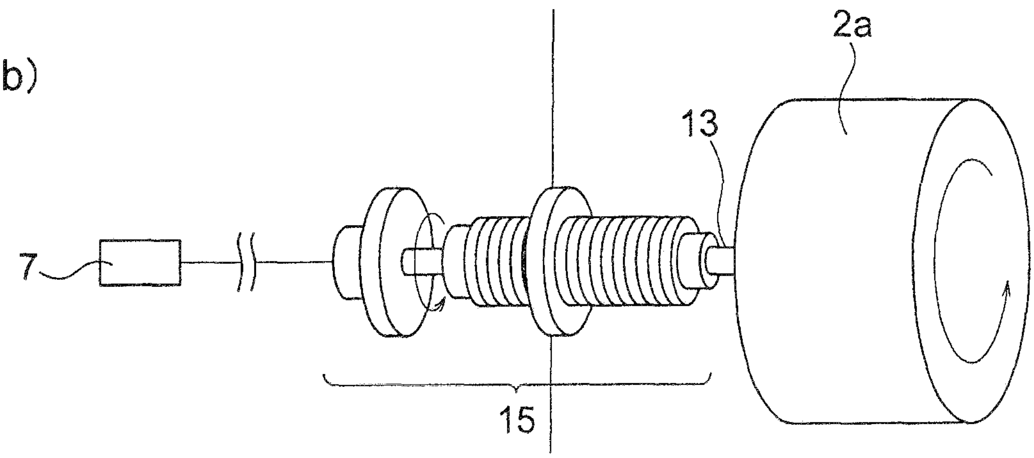

F I G. 4

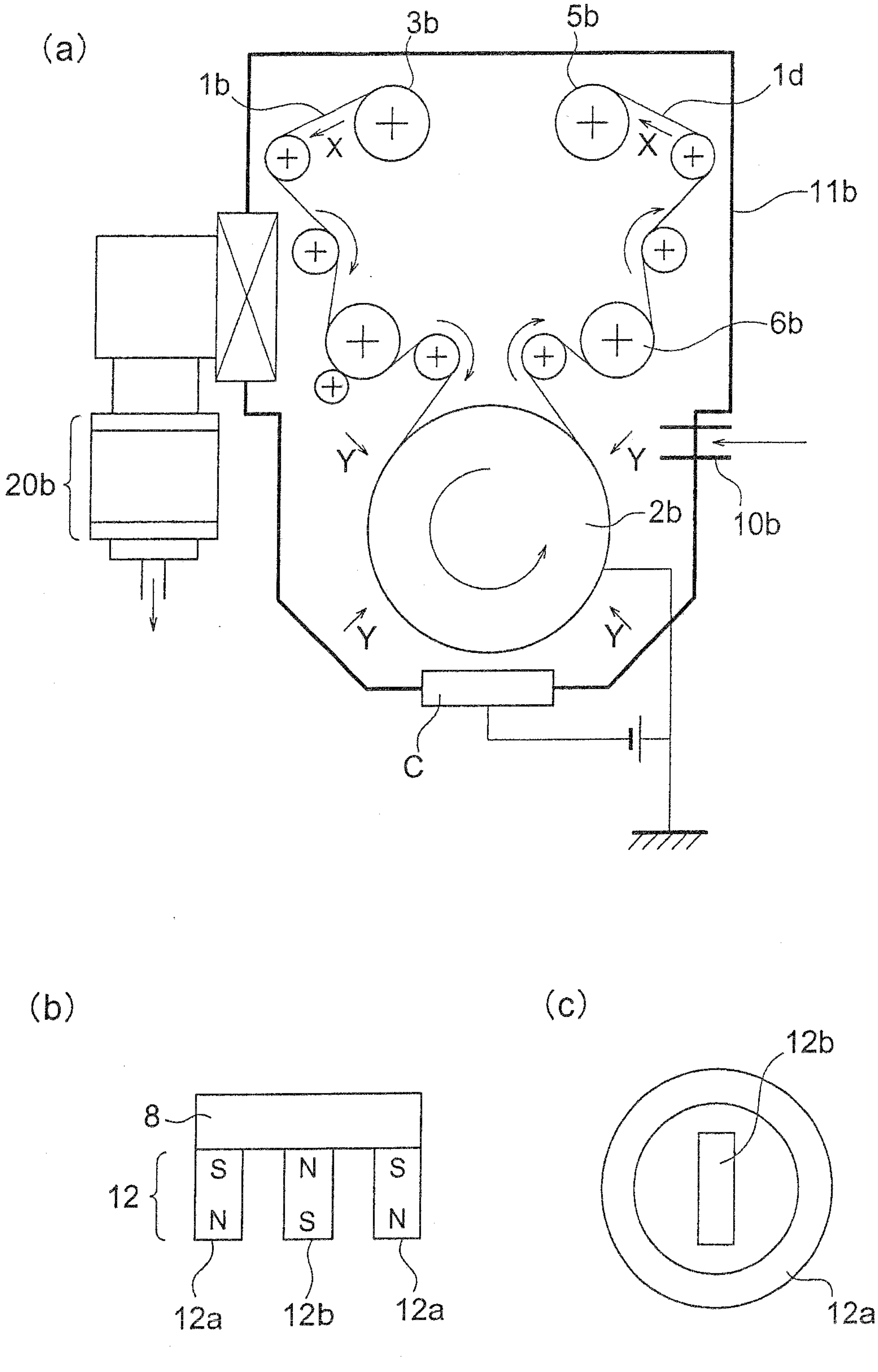
(a)
3b
5b
1b
1d
X
X
11b
6b
20b
Y
Y
Y
Y
2b
10b
C
(b)
(c)
12b
8
S
N
S
12
N
S
N
12a
12b
12a
12a

F I G. 5

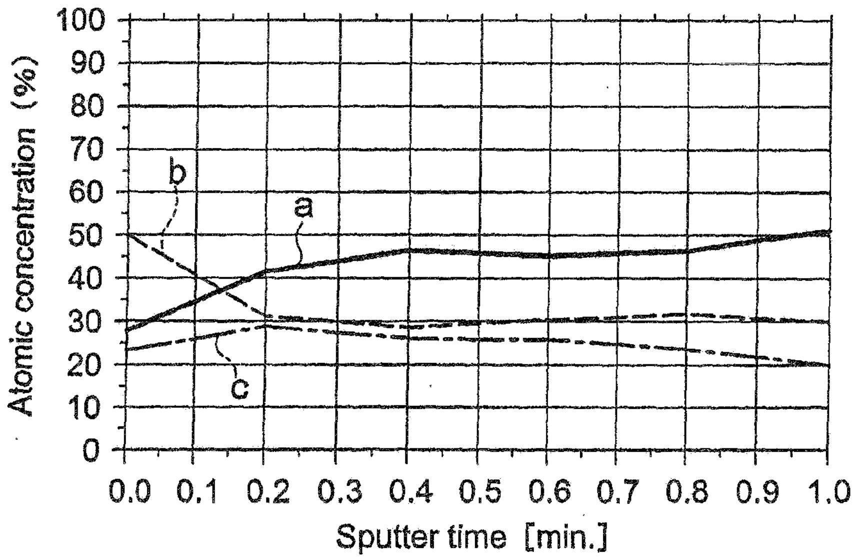
Atomic concentration (%)
100
90
80
70
60
50
40
30
20
10
0
b
a
c
0.0 0.1 0.2 0.3 0.4 0.5 0.6 0.7 0.8 0.9 1.0
Sputter time [min.]

F I G. 6

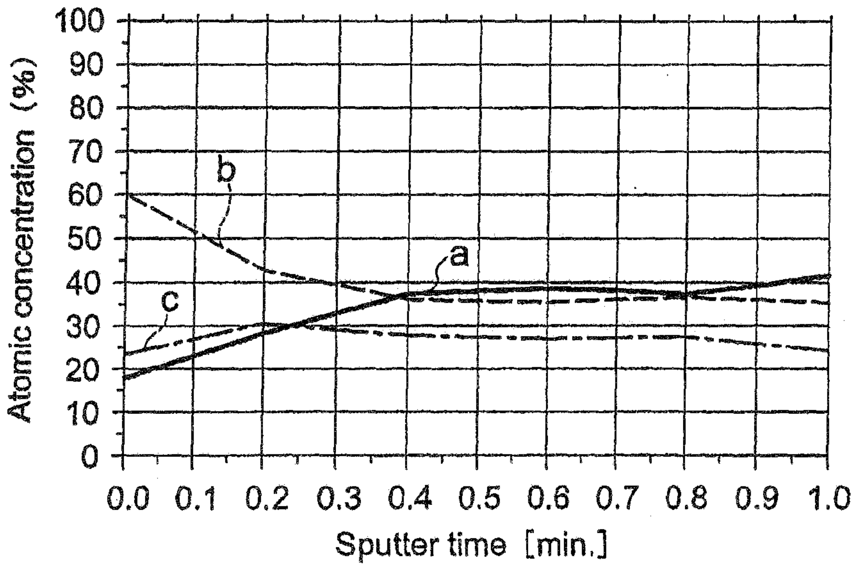
Atomic concentration (%)
100
90
80
70
60
50
40
30
20
10
0
b
a
c
0.0 0.1 0.2 0.3 0.4 0.5 0.6 0.7 0.8 0.9 1.0
Sputter time [min.]

FIG. 7

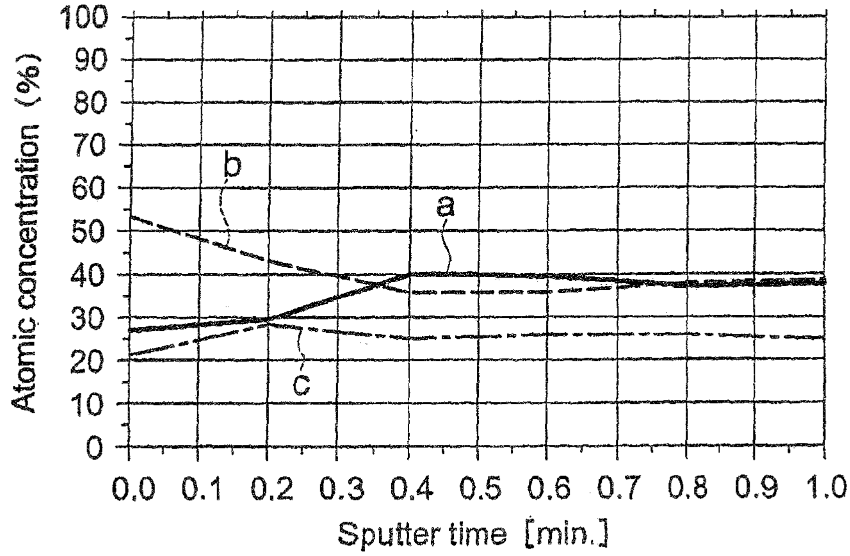
100
90
80
70
60
50
40
30
20
10
0
Atomic concentration (%)
a
b
c
0.0 0.1 0.2 0.3 0.4 0.5 0.6 0.7 0.8 0.9 1.0
Sputter time [min.]

FIG. 8

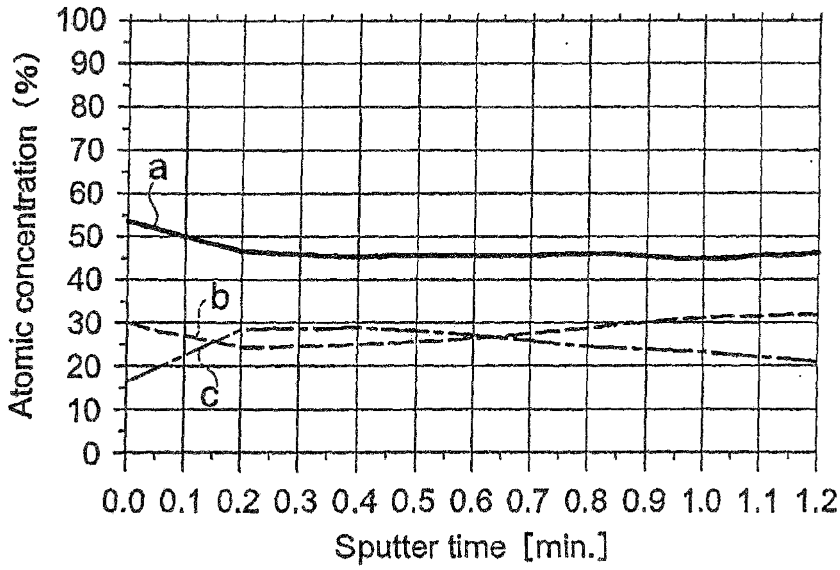
100
90
80
70
60
50
40
30
20
10
0
Atomic concentration (%)
a
b
c
0.0 0.1 0.2 0.3 0.4 0.5 0.6 0.7 0.8 0.9 1.0 1.1 1.2
Sputter time [min.]

F I G. 9

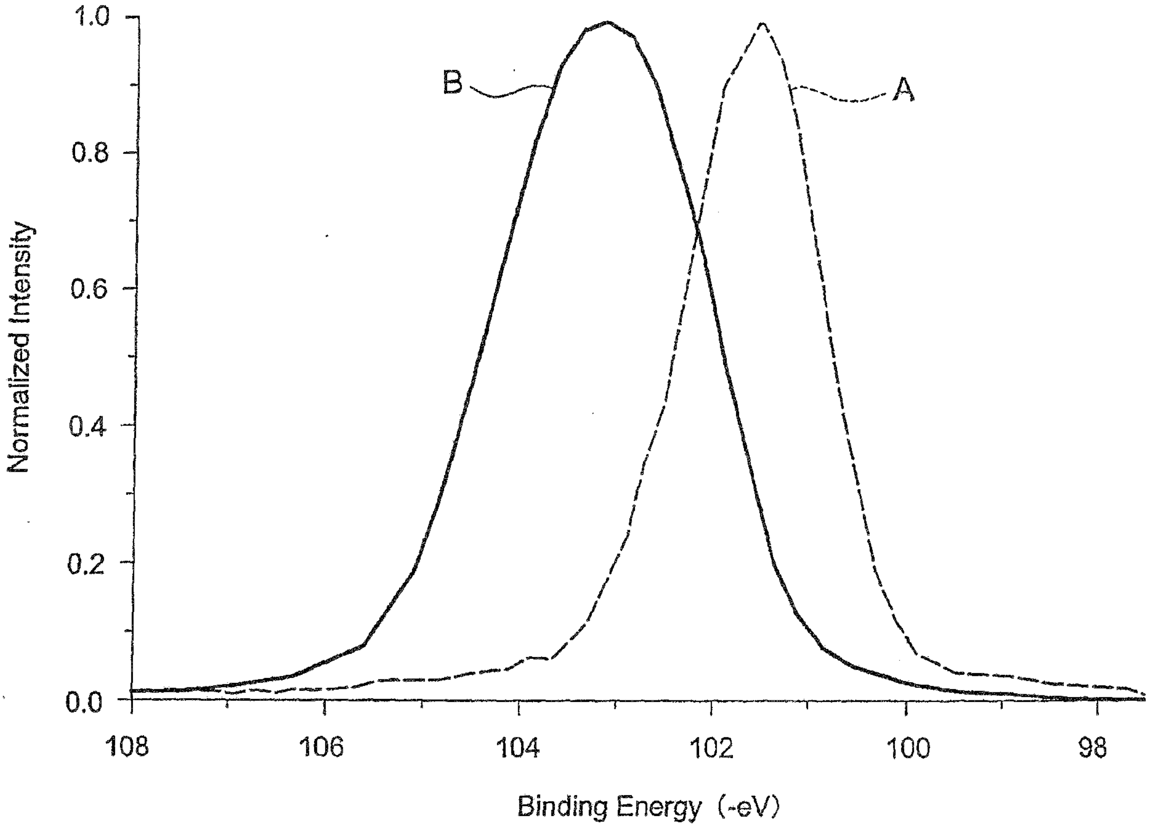
1.0
0.8
0.6
0.4
0.2
0.0
Normalized Intensity
B
A
108
106
104
102
100
98
Binding Energy (-eV)

**INTERNATIONAL SEARCH REPORT**

International application No.
PCT/JP2009/070728

A. CLASSIFICATION OF SUBJECT MATTER
*B32B9/04*(2006.01)i, *B32B27/00*(2006.01)i

According to International Patent Classification (IPC) or to both national classification and IPC

B. FIELDS SEARCHED

Minimum documentation searched (classification system followed by classification symbols)
B32B1/00-43/00, C23C14/00-14/58, H01B5/00-5/16, G02F1/1333

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2006-035737 A (Teijin Ltd.), 09 February 2006 (09.02.2006), claims; paragraphs [0007], [0037]; examples (Family: none) | 1-15 |
| Y | JP 05-185568 A (Diafoil Hoechst Co., Ltd.), 27 July 1993 (27.07.1993), claims; paragraph [0014]; examples (Family: none) | 1-15 |
| Y | JP 2008-204683 A (Toppan Printing Co., Ltd.), 04 September 2008 (04.09.2008), claims; paragraph [0014] (Family: none) | 1-15 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 28 January, 2010 (28.01.10) | 09 February, 2010 (09.02.10) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.
PCT/JP2009/070728

C (Continuation). DOCUMENTS CONSIDERED TO BE RELEVANT

| Category* | Citation of document, with indication, where appropriate, of the relevant passages | Relevant to claim No. |
|---|---|---|
| Y | JP 09-124807 A (Nissin Electric Co., Ltd.), 13 May 1997 (13.05.1997), claims; paragraph [0010] (Family: none) | 1-15 |
| Y | JP 2006-070238 A (Lintec Corp.), 16 March 2006 (16.03.2006), claims; paragraphs [0023], [0024] (Family: none) | 1-15 |
| Y | JP 08-057560 A (Hughes Aircraft Co.), 05 March 1996 (05.03.1996), claims; paragraph [0010] & EP 0499197 A2 & US 5143747 A | 1-15 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005169994 A
- JP 10305542 A
- JP 2001119051 A
- JP 2003347570 A
- JP 2004352966 A